# EUROPEAN PATENT APPLICATION

(11) **EP 4 538 966 A1**
(43) Date of publication of application: **16.04.2025**
(21) Application number: 24205960.8
(22) Date of filing: 10.10.2024
(51) Int. Cl.: G06T 7/00

(54) **PIXEL COMPARISON**

(30) Priority: 13.10.2023 GB 202315734
(71) Applicant: Imagination Technologies Limited, Kings Langley, Hertfordshire WD4 8LZ (GB)
(72) Inventor: Jasinski, Marcin, Kings Langley, WD4 8LZ (GB); Czajka, Artur, Kings Langley, WD4 8LZ (GB); Morphet, Stephen, Kings Langley, WD4 8LZ (GB)
(74) Representative: Slingsby Partners LLP

(57) **Abstract**

A method of classifying a first pixel in a first group of neighbouring pixels as acceptable or not acceptable with respect to a second pixel in a second group of neighbouring pixels, the method comprising: determining whether a difference between the first pixel and the second pixel is greater than a threshold difference; in response to determining that the difference between the first pixel and the second pixel is greater than the threshold difference, analysing the pixels in at least one of the first and second groups of neighbouring pixels to determine whether the difference is indicative of the first pixel being erroneous; classifying the first pixel as acceptable or not acceptable based on whether the difference is determined to be indicative of the first pixel being erroneous; and outputting the classification of the first pixel.

## Description

### CROSS-REFERENCE TO RELATED APPLICATION

This application claims priority from UK patent application no. 2315734.0 filed on 13 October 2023, which is herein incorporated by reference in its entirety.

### TECHNICAL FIELD

This application relates to approaches to comparing pixels, e.g. for classifying pixels as acceptable or for determining a metric indicative of a similarity between a first block of pixels and a second block of pixels.

### BACKGROUND

Image data can be generated using a variety of techniques. For example, an image may be produced as part of a rendering process on a Graphics Processing Unit (GPU). The term 'image data' is used herein to refer to two-dimensional data that has values corresponding to respective pixel or sample locations of an image. Image data may include, but is not limited to, depth data to be stored in a depth buffer, pixel data (e.g. colour data) to be stored in a frame buffer, texture data to be stored in a texture buffer, surface normal data to be stored in a surface normal buffer and lighting data to be stored in a lighting buffer.

A GPU may be used to process data in order to generate image data. For example, a GPU may determine pixel values (e.g. colour values) of pixels of an image to be stored in a frame buffer which may be output to a display. It is desirable, when developing techniques for generating image data (and GPUs for implementing those techniques), to be able to determine when a pixel value has been incorrectly determined so that the efficacy of the technique can be measured. To determine when such techniques are outputting errors, approaches to testing image rendering techniques commonly involve comparing the generated image data with reference image data, e.g. comparing the generated pixels with reference pixels. If the difference between a generated pixel and its corresponding reference pixel is greater than a threshold then this can be considered to be indicative of the generated pixel being erroneous. Once an error has been identified, the designer of the processing unit is able to investigate the error further to determine its cause to improve the image rendering technique. The investigation of the error is often a time consuming process for the designer of the processing unit, so it is generally desirable not to identify pixels as being erroneous when they are acceptable.

The same issues may be relevant for other processing units, e.g. central processing units (CPUs), as well as GPUs.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

There is provided a method of classifying a first pixel in a first group of neighbouring pixels as acceptable or not acceptable with respect to a second pixel in a second group of neighbouring pixels, the method comprising determining whether a difference between the first pixel and the second pixel is greater than a threshold difference; in response to determining that the difference between the first pixel and the second pixel is greater than the threshold difference, analysing the pixels in at least one of the first and second groups of neighbouring pixels to determine whether the difference is indicative of the first pixel being erroneous; classifying the first pixel as acceptable or not acceptable based on whether the difference is determined to be indicative of the first pixel being erroneous; and outputting the classification of the first pixel.

A first region of pixels may comprise the first group of neighbouring pixels and a second region of pixels may comprise the second group of neighbouring pixels, and analysing the pixels in at least one of the first and second groups of neighbouring pixels to determine whether the difference is indicative of the first pixel being erroneous may comprise determining, for each pixel in the first region, a difference between the pixel and a corresponding pixel in the second region and whether the difference between the pixel and the corresponding pixel is greater than a second threshold difference; calculating the number of pixels in the first region for which the difference between the pixel and the corresponding pixel is less than the second threshold difference; and determining whether the number of pixels in the first region for which the difference between the pixel and the corresponding pixel is less than the second threshold difference is greater than a threshold number of pixels.

The first region of pixels may be the first group of neighbouring pixels and the second region of pixels may be the second group of neighbouring pixels.

Analysing the pixels in at least one of the first and second groups of neighbouring pixels to determine whether the difference is indicative of the first pixel being erroneous may comprise determining whether a difference between the first pixel and each of the pixels in the second group of neighbouring pixels is greater than a third threshold difference.

The method may comprise classifying the first pixel as acceptable in response to determining that the difference between the first pixel and at least one of the pixels in the second group of neighbouring pixels is less than the third threshold difference.

Analysing the pixels in at least one of the first and second groups of neighbouring pixels to determine whether the difference is indicative of the first pixel being erroneous may comprise determining whether a difference between the first pixel and each of the pixels in the first group of neighbouring pixels is greater than a fourth threshold difference; determining a primary connection between the first pixel and any pixel in the first group of neighbouring pixels for which the difference between the two pixels is not greater than the fourth threshold difference; determining whether a difference between each pixel in the first group of neighbouring pixels and each adjacent pixel in the first group of neighbouring pixels is greater than the fourth threshold difference; determining a secondary connection between any two adjacent pixels in the first group of neighbouring pixels for which the difference between the two pixels is not greater than the fourth threshold difference; determining whether the number of primary connections determined between the first pixel and the first group of neighbouring pixels is greater than a first connection threshold; determining a total number of connections as the sum of the number of primary connections and the number of secondary connections; and determining whether the total number of connections determined within the first group of neighbouring pixels is greater than a second connection threshold.

Analysing the pixels in at least one of the first and second groups of neighbouring pixels to determine whether the difference is indicative of the first pixel being erroneous may comprise determining whether a difference between the second pixel and each of the pixels in the second group of neighbouring pixels is greater than the fourth threshold difference; determining whether a difference between each pixel in the second group of neighbouring pixels and each adjacent pixel in the second group of neighbouring pixels is greater than the fourth threshold difference; determining a primary connection between the second pixel and any pixel in the second group of neighbouring pixels for which the difference between the two pixels is not greater than the fourth threshold difference; determining a secondary connection between any two adjacent pixels in the second group of neighbouring pixels for which the difference between the two pixels is not greater than the fourth threshold difference; determining whether the number of primary connections determined between the second pixel and the second group of neighbouring pixels is greater than the first connection threshold; determining a total number of connections as the sum of the number of primary connections and the number of secondary connections; and determining whether the total number of connections determined within the second group of neighbouring pixels is greater than the second connection threshold.

The method may comprise classifying the first pixel as acceptable in response to determining that the number of primary connections determined between the first pixel and the first group of neighbouring pixels is greater than the first connection threshold; the total number of connections determined within the first group of neighbouring pixels is greater than the second connection threshold; the number of primary connections determined between the second pixel and the second group of neighbouring pixels is greater than the first connection threshold; and the total number of connections determined within the second group of neighbouring pixels is greater than the second connection threshold.

Analysing the pixels in at least one of the first and second groups of neighbouring pixels to determine whether the difference is indicative of the first pixel being erroneous comprises, for each pair of pixels in the first group of neighbouring pixels which flank the first pixel comparing a colour value of each pixel of the pair of flanking pixels to a colour value of the first pixel; and determining whether the colour value of the first pixel lies between the colour value of a first flanking pixel in the pair of flanking pixels and the colour value of a second flanking pixel in the pair of flanking pixels for a plurality of channels of the colour values.

The method may comprise classifying the first pixel as acceptable in response to determining that, for at least one pair of flanking pixels comprising a first flanking pixel and a second flanking pixel, the colour value of the first pixel lies between the colour value of the first flanking pixel and the colour value of the second flanking pixel for the plurality of channels of the colour values.

Analysing the pixels in at least one of the first and second groups of neighbouring pixels to determine whether the difference is indicative of the first pixel being erroneous may comprise, for each pair of pixels in the second group of neighbouring pixels which flank the second pixel: comparing a colour value of each pixel of the pair of flanking pixels to a colour value of the second pixel; and determining whether the colour value of the second pixel lies between the colour value of a first flanking pixel in the pair of flank pixels and the colour value of a second flanking pixel in the pair of flanking pixels for a plurality of channels of the colour values.

The method may comprise classifying the first pixel as acceptable in response to determining that, for at least one pair of flanking pixels comprising a first flanking pixel and a second flanking pixel, the colour value of the second pixel lies between the colour value of the first flanking pixel and the colour value of the second flanking pixel for the plurality of channels of the colour values.

The plurality of channels may be all the channels of the colour values.

Analysing the pixels in at least one of the first and second groups of neighbouring pixels may comprise analysing the pixels in both the first and second groups of neighbouring pixels.

Analysing the pixels in at least one of the first and second groups of neighbouring pixels to determine whether the difference is indicative of the first pixel being erroneous may comprise, for the first group of neighbouring pixels, comparing a colour value of the first pixel to a corresponding colour value of each of the pixels in the first group of neighbouring pixels; determining whether the colour value of the first pixel is greater or less than the colour value of all of the pixels in the first group of neighbouring pixels for all channels of the colour values; and, for the second group of neighbouring pixels, comparing a colour value of the second pixel to a corresponding colour value of each of the pixels in the second group of neighbouring pixels; determining whether the colour value of the second pixel is greater or less than the colour value of all of the pixels in the second group of neighbouring pixels for all channels of the colour values; and determining whether a difference between the first pixel and the second pixel is less than a fifth threshold difference.

The method may comprise classifying the first pixel as acceptable in response to determining that the colour value of the first pixel is greater than the colour value of all of the pixels in the first group of neighbouring pixels for all channels in the colour values and the colour value of the second pixel is greater than the colour value of all of the pixels in the second group of neighbouring pixels for all channels in the colour values; or the colour value of the first pixel is less than the colour value of all of the pixels in the first group of neighbouring pixels for all channels in the colour values the colour value of the second pixel is less than the colour value of all of the pixels in the second group of neighbouring pixels for all channels in the colour values; and that difference between the first pixel and the second pixel is less than the fifth threshold difference.

The method may comprise classifying the first pixel as acceptable in response to determining that the number of primary connections determined between the first pixel and the first group of neighbouring pixels is greater than the first connection threshold; the number of secondary connections determined within the first group of neighbouring pixels is greater than the second connection threshold; and the colour value of the second pixel lies between the colour value of a first flanking pixel in the pair of flanking pixels and the colour value of a second flanking pixel in the pair of flanking pixels for all channels of the colour values.

The method may comprise classifying the first pixel as acceptable in response to determining that the number of primary connections determined between the second pixel and the second group of neighbouring pixels is greater than the first connection threshold; the number of secondary connections determined within the second group of neighbouring pixels is greater than the second connection threshold; and the colour value of the first pixel lies between the colour value of a first flanking pixel in the pair of flanking pixels and the colour value of a second flanking pixel in the pair of flanking pixels for all channels of the colour values.

Classifying the first pixel as acceptable may indicate that the difference is indicative of floating point rounding.

The first group of neighbouring pixels may be in a first image and the second group of neighbouring pixels may be in a second image.

The first group of neighbouring pixels may be a square of 3 pixels by 3 pixels and the second group of neighbouring pixels may be a square of 3 pixels by 3 pixels.

There is provided a processing unit configured to classify a first pixel in a first group of neighbouring pixels as acceptable or not acceptable with respect to a second pixel in a second group of neighbouring pixels, the processing unit being configured to determine whether a difference between the first pixel and the second pixel is greater than a threshold difference; in response to determining that the difference between the first pixel and the second pixel is greater than the threshold difference, analyse the pixels in at least one of the first and second groups of neighbouring pixels to determine whether the difference is indicative of the first pixel being erroneous; classify the first pixel as acceptable or not acceptable based on whether the difference is determined to be indicative of the first pixel being erroneous; and output the classification of the first pixel.

There is provided computer readable code configured to cause the method of classifying a first pixel in a first group of neighbouring pixels as acceptable or not acceptable with respect to a second pixel in a second group of neighbouring pixels to be performed when the code is run.

There is provided a computer readable storage medium having encoded thereon the computer readable code configured to cause the method of classifying a first pixel in a first group of neighbouring pixels as acceptable or not acceptable with respect to a second pixel in a second group of neighbouring pixels.

There may be provided a method for determining a metric indicative of a similarity between a first block of pixels and a second block of pixels, wherein the metric is determined as a combination of terms based on the differences between corresponding pixels in the blocks of pixels, the method comprising determining a term of the combination of terms for each pair of corresponding pixels in the first and second blocks of pixels by determining a difference between a first pixel in the first block of pixels and a corresponding second pixel in the second block of pixels; in response to determining that the difference between the first pixel and the second pixel is greater than a threshold difference, analysing the pixels in at least one of a first group of neighbouring pixels in the first block of pixels and a second group of neighbouring pixels in the second block of pixels to determine an extent to which the difference is to contribute to determining the term of the combination of terms wherein the first pixel is in the first group of neighbouring pixels and the second pixel is in the second group of neighbouring pixels; and determining the term of the combination of terms based on the determination of the extent to which the difference is to contribute to determining the term of the combination of terms; and determining the metric indicative of the similarity between the first block of pixels and the second block of pixels by calculating the combination of terms.

The first region of pixels may comprise the first group of neighbouring pixels, a second region of pixels may comprise the second group of neighbouring pixels, the first block of pixels may comprise the first region of pixels and the second block of pixels may comprise the second region of pixels, and analysing the pixels in at least one of the first and second groups of neighbouring pixels to determine the extent to which the difference is to contribute to determining the term of the combination of terms may comprise determining, for each pixel in the first region, a difference between the pixel and a corresponding pixel in the second region and whether the difference between the pixel and the corresponding pixel is greater than a second threshold difference; calculating the number of pixels in the first region for which the difference between the pixel and the corresponding pixel is less than the second threshold difference; and determining whether the number of pixels in the first region for which the difference between the pixel and the corresponding pixel is less than the second threshold difference is greater than a threshold number of pixels.

The first region of pixels may be the first group of neighbouring pixels and the second region of pixels may be the second group of neighbouring pixels.

Analysing the pixels in at least one of the first and second groups of neighbouring pixels to determine the extent to which the difference is to contribute to determining the term of the combination of terms may comprise determining whether a difference between the first pixel and each of the pixels in the second group of neighbouring pixels is greater than a third threshold difference.

The method may comprise determining that the extent to which the difference is to contribute to determining the term of the combination of terms is reduced in response to determining that the difference between the first pixel and at least one of the pixels in the second group of neighbouring pixels is less than the third threshold difference.

Analysing the pixels in at least one of the first and second groups of neighbouring pixels to determine the extent to which the difference is to contribute to determining the term of the combination of terms may comprise determining whether a difference between the first pixel and each of the pixels in the first group of neighbouring pixels is greater than a fourth threshold difference; determining a primary connection between the first pixel and any pixel in the first group of neighbouring pixels for which the difference between the two pixels is not greater than the fourth threshold difference; determining whether a difference between each pixel in the first group of neighbouring pixels and each adjacent pixel in the first group of neighbouring pixels is greater than the fourth threshold difference; determining a secondary connection between any two adjacent pixels in the first group of neighbouring pixels for which the difference between the two pixels is not greater than the fourth threshold difference; determining whether the number of primary connections determined between the first pixel and the first group of neighbouring pixels is greater than a first connection threshold; determining a total number of connections as the sum of the number of primary connections and the number of secondary connections; and determining whether the total number of connections determined within the first group of neighbouring pixels is greater than a second connection threshold.

Analysing the pixels in at least one of the first and second groups of neighbouring pixels to determine the extent to which the difference is to contribute to determining the term of the combination of terms may comprise determining whether a difference between the second pixel and each of the pixels in the second group of neighbouring pixels is greater than the fourth threshold difference; determining whether a difference between each pixel in the second group of neighbouring pixels and each adjacent pixel in the second group of neighbouring pixels is greater than the fourth threshold difference; determining a primary connection between the second pixel and any pixel in the second group of neighbouring pixels for which the difference between the two pixels is not greater than the fourth threshold difference; determining a secondary connection between any two adjacent pixels in the second group of neighbouring pixels for which the difference between the two pixels is not greater than the fourth threshold difference; determining whether the number of primary connections determined between the second pixel and the second group of neighbouring pixels is greater than the first connection threshold; determining a total number of connections as the sum of the number of primary connections and the number of secondary connections; and determining whether the number of connections determined within the second group of neighbouring pixels is greater than the second connection threshold.

The method may comprise determining that the extent to which the difference is to contribute to determining the term of the combination of terms is reduced in response to determining that the number of primary connections determined between the first pixel and the first group of neighbouring pixels is greater than the first connection threshold; the total number of connections determined within the first group of neighbouring pixels is greater than the second connection threshold; the number of primary connections determined between the second pixel and the second group of neighbouring pixels is greater than the first connection threshold; and the total number of connections determined within the second group of neighbouring pixels is greater than the second connection threshold.

Analysing the pixels in at least one of the first and second groups of neighbouring pixels to determine the extent to which the difference is to contribute to determining the term of the combination of terms may comprise, for each pair of pixels in the first group of neighbouring pixels which flank the first pixel, comparing a colour value of each pixel of the pair of flanking pixels to a colour value of the first pixel; and determining whether the colour value of the first pixel lies between the colour value of a first flanking pixel in the pair of flanking pixels and the colour value of a second flanking pixel in the pair of flanking pixels for a plurality of channels of the colour values.

The method may comprise determining that the extent to which the difference is to contribute to determining the term of the combination of terms is reduced in response to determining that the colour value of the first pixel lies between the colour value of a first flanking pixel in the pair of flanking pixels and the colour value of a second flanking pixel in the pair of flanking pixels for the plurality of channels of the colour values.

Analysing the pixels in at least one of the first and second groups of neighbouring pixels to determine the extent to which the difference is to contribute to determining the term of the combination of terms may comprise, for each pair of pixels in the second group of neighbouring pixels which flank the second pixel, comparing a colour value of each pixel of the pair of flanking pixels to a colour value of the second pixel; and determining whether the colour value of the second pixel lies between the colour value of a first flanking pixel in the pair of flank pixels and the colour value of a second flanking pixel in the pair of flanking pixels for a plurality of channels of the colour values.

The method may comprise determining that the extent to which the difference is to contribute to determining the term of the combination of terms is reduced in response to determining that the colour value of the second pixel lies between the colour value of a first flanking pixel in the pair of flanking pixels and the colour value of a second flanking pixel in the pair of flanking pixels for the plurality of channels of the colour values.

The plurality of channels may be all the channels of the colour values.

Analysing the pixels in at least one of the first and second groups of neighbouring pixels may comprise analysing the pixels in both the first and second groups of neighbouring pixels.

Analysing the pixels in at least one of the first and second groups of neighbouring pixels to determine the extent to which the difference is to contribute to determining the term of the combination of term may comprise, for the first group of neighbouring pixels, comparing a colour value of the first pixel to a corresponding colour value of each of the pixels in the first group of neighbouring pixels; and determining whether the colour value of the first pixel is greater or less than the colour value of all of the pixels in the first group of neighbouring pixels for all channels of the colour values; and for the second group of neighbouring pixels, comparing a colour value of the second pixel to a corresponding colour value of each of the pixels in the second group of neighbouring pixels; and determining whether the colour value of the second pixel is greater or less than the colour value of all of the pixels in the second group of neighbouring pixels for all channels of the colour values; and determining whether a difference between the first pixel and the second pixel is less than a fifth threshold difference.

The method may comprise determining that the extent to which the difference is to contribute to determining the term of the combination of terms is reduced in response to determining that the colour value of the first pixel is greater than the colour value of all of the pixels in the first group of neighbouring pixels for all channels in the colour values and the colour value of the second pixel is greater than the colour value of all of the pixels in the second group of neighbouring pixels for all channels in the colour values; or the colour value of the first pixel is less than the colour value of all of the pixels in the first group of neighbouring pixels for all channels in the colour values the colour value of the second pixel is less than the colour value of all of the pixels in the second group of neighbouring pixels for all channels in the colour values; and that difference between the first pixel and the second pixel is less than the fifth threshold difference.

The method may comprise determining that the extent to which the difference is to contribute to determining the term of the combination of terms is reduced in response to determining that: the number of primary connections determined between the first pixel and the first group of neighbouring pixels is greater than the first connection threshold; the number of secondary connections determined within the first group of neighbouring pixels is greater than the second connection threshold; and the colour value of the second pixel lies between the colour value of a first flanking pixel in the pair of flanking pixels and the colour value of a second flanking pixel in the pair of flanking pixels for all channels of the colour values.

The method may comprise determining that the extent to which the difference is to contribute to determining the term of the combination of terms is reduced in response to determining that the number of primary connections determined between the second pixel and the second group of neighbouring pixels is greater than the first connection threshold; the number of secondary connections determined within the second group of neighbouring pixels is greater than the second connection threshold; and the colour value of the first pixel lies between the colour value of a first flanking pixel in the pair of flanking pixels and the colour value of a second flanking pixel in the pair of flanking pixels for all channels of the colour values.

The first block of pixels may be in a first frame of a series of frames and the second block of pixels may be in a second frame of a series of frames.

The first group of neighbouring pixels may be a square of 3 pixels by 3 pixels and the second group of neighbouring pixels may be a square of 3 pixels by 3 pixels.

Determining the extent to which the difference is to contribute to determining the term of the combination of terms may comprise determining that the difference does not contribute to determining the term.

Determining the term of the combination of terms may comprise determining the term as zero.

Determining the extent to which the difference is to contribute to determining the term of the combination of terms may comprise determining that the difference does contribute to determining the term.

Determining the term of the combination of terms may comprise determining the term as equal to the difference or equal to the square of the difference.

The method may comprise using the metric as part of a motion estimation algorithm.

The method may comprise using the metric as part of training a neural network to perform image recognition.

The combination of terms may be a sum of terms.

The sum of terms may be a sum of absolute differences or a sum of squared differences.

There may also be provided a processing unit configured to determine a metric indicative of a similarity between a first block of pixels and a second block of pixels, wherein the metric is determined as a combination of terms based on the differences between corresponding pixels in the blocks of pixels, the processing unit being configured to determine a term of the combination of terms for each pair of corresponding pixels in the first and second blocks of pixels by determining a difference between a first pixel in the first block of pixels and a corresponding second pixel in the second block of pixels; in response to determining that the difference between the first pixel and the second pixel is greater than a threshold difference, analysing the pixels in at least one of a first group of neighbouring pixels in the first block of pixels and a second group of neighbouring pixels in the second block of pixels to determine an extent to which the difference is to contribute to determining the term of the combination of terms, wherein the first pixel is in the first group of neighbouring pixels and the second pixel is in the second group of neighbouring pixels; and determining the term of the combination of terms based on the determination of the extent to which the difference is to contribute to determining the term of the combination of terms; and determine the metric indicative of the similarity between the first block of pixels and the second block of pixels by calculating the combination of terms.

There may further be provided computer readable code configured to cause the method for determining a metric indicative of a similarity between a first block of pixels and a second block of pixels to be performed when the code is run.

There may be provided computer program code for performing any of the methods described herein. There may be provided non-transitory computer readable storage medium having stored thereon computer readable instructions that, when executed at a computer system, cause the computer system to perform any of the methods described herein.

The above features may be combined as appropriate, as would be apparent to a skilled person, and may be combined with any of the aspects of the examples described herein.

### BRIEF DESCRIPTION OF THE DRAWINGS

Examples will now be described in detail with reference to the accompanying drawings in which:
Figure 1 shows a block of image data generated using an image rendering technique and a block of reference data.
Figure 2 shows a block of image data featuring a boundary between two colours and a block of reference image data.
Figure 3 shows the same block of image data featuring a boundary between two colours and block of reference image data and additionally identifies groups of neighbouring pixels in both blocks of image data.
Figure 4 shows a method of classifying a pixel in a group of neighbouring pixels as acceptable or not acceptable.
Figure 5 shows an example of a method for determining whether a pixel in a block of generated image data should be classified as acceptable or not acceptable.
Figure 6 shows the same block of image data featuring a boundary between two colours and block of reference image data as shown in Figure 3, and additionally identifies regions of pixels in both blocks of image data.
Figure 7 shows a different block of image data and a block of reference image data and the regions of pixels in both blocks of image data.
Figure 8 shows a group of neighbouring pixels from a block of image data, a group of neighbouring pixels from a block of reference image data and connections formed between pixels in both blocks of image data as part of performing a second test.
Figure 9 shows a group of neighbouring pixels from a block of image data and a group of neighbouring pixels from a block of reference image data which meet the conditions of a third test.
Figure 10 shows a group of neighbouring pixels from a block of image data and a group of neighbouring pixels from a block of reference image data which meet the conditions of a fourth test.
Figure 11 shows an example of a method for determining whether a pixel in a block of generated image data should be classified as acceptable or not acceptable.
Figure 12 shows two consecutive frames of a series of frames, each frame including blocks of pixels.
Figure 13 shows a method for determining a metric indicative of a similarity between a first block of pixels and a second block of pixels.
Figure 14 shows an example of a method for determining a metric indicative of a similarity between a first block of pixels and a second block of pixels.
Figure 15 illustrates a computer system comprising a processing unit and a memory.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

### DETAILED DESCRIPTION

The following description is presented by way of example to enable a person skilled in the art to make and use the invention. The present invention is not limited to the embodiments described herein and various modifications to the disclosed embodiments will be apparent to those skilled in the art.

Embodiments will now be described by way of example only.

Rendering processes which can be used for generating pixels of a rendered image tend not to be perfectly accurate or infinitely precise. For example, some numbers cannot be represented with infinite precision (e.g. in a floating point format) in a rendering system due to constraints on the numbers of bits used to represent those numbers. Floating point rounding occurs when a value is rounded to a representable value in the floating point format being used in the system. Different rounding modes may be acceptable, e.g. the IEEE standard for floating point arithmetic defines various rounding modes, including: (i) a round to nearest (with ties rounded to the nearest even value) mode, (ii) a round to nearest (with ties rounded away from zero) mode, (iii) a round up (or round towards positive infinity) mode, (iv) a round down (or round towards negative infinity) mode, and (v) a round towards zero (i.e. truncation) mode. Rounding, and the use of different rounding modes, can give rise to small differences (or imprecisions) in values that are used in the rendering process, and these differences are acceptable, i.e. they are not indicative of errors in the rendering process. Often these differences will not be perceptible in the rendered pixel values, but in some situations these differences (or imprecisions) could result in large differences in the rendered pixel values. For example, if a value representing the position of a vertex of a primitive is altered very slightly this could affect whether or not that primitive overlaps a pixel position, such that it could have a huge effect on the colour of the pixel that is rendered at that pixel position (e.g. if the primitive has a different colour to an adjacent pixel). In these situations a large difference between a rendered pixel and a corresponding reference pixel can occur even though the rendered pixel is not erroneous. Slight differences in an image rendering technique (e.g. due to floating point rounding) are acceptable even though these slight differences can sometimes lead to large differences between rendered pixels and corresponding reference pixels.

Conventional approaches to determining whether a pixel is erroneous are not able to identify situations in which a large difference between a rendered pixel and a reference pixel is acceptable, e.g. due to floating point rounding as described above. As described above, some differences (e.g. due to floating point rounding) are not indicative of an error in the image rendering technique. For these differences (e.g. due to a floating point rounding), there is no need for the designer of the processing unit to investigate the cause of the differences further to determine their cause. The techniques described herein provide an approach for classifying pixels as acceptable or not acceptable, and can distinguish between: (i) differences between rendered pixels and reference pixels which are indicative of the pixels being erroneous (i.e. true errors in the rendering process), and (ii) differences between rendered pixels and reference pixels which are not indicative of the pixels being erroneous, e.g. differences caused by floating point rounding. The techniques described herein can distinguish between these two situations for a rendered pixel by analysing the pixels neighbouring the rendered pixel and/or the pixels neighbouring the reference pixel to determine whether a difference between the rendered pixel and the reference pixel is indicative of the rendered pixel being erroneous.

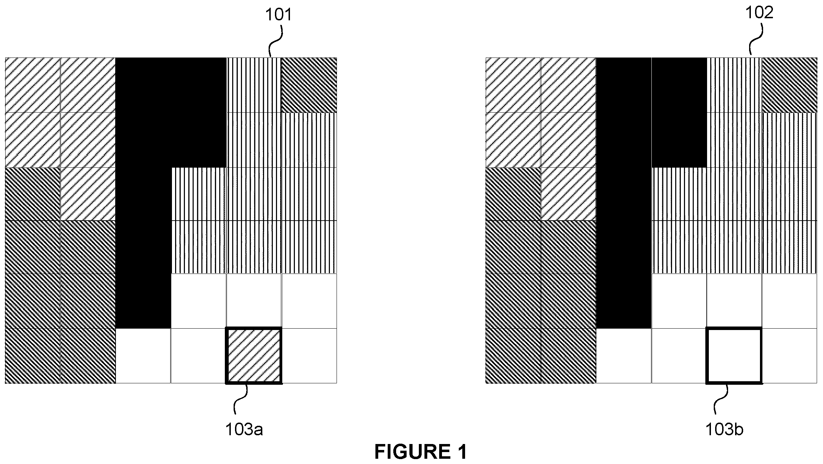

Figure 1 illustrates block of image data 101 generated using an image rendering technique and a block of reference image data 102. Both blocks of image data are illustrated as being 6x6 blocks of pixels but according to other examples may comprise any number of pixels and may or may not be square. Figure 1 shows that the generated image data 101 is identical to the reference image 102 except for pixel 1 03a/b. The block of generated image data 101 may be image data of a first image. The block of reference image data 102 may be data of a second image. Alternatively, the block of generated image data 101 and the block of reference image data 102 may be two blocks of image data in the same image.

As previously discussed, known approaches to testing the efficacy of image rendering techniques involve comparing the generated image data 101 with reference image data 102. These approaches involve determining errors in the generated image data 101 by comparing a pixel in the block of generated image data 101 to its corresponding pixel in the reference image data 102 and repeating this for each pixel in the generated image data 101. In the example of figure 1, this will involve comparing each of the 36 pixels in the generated image data 101 with its corresponding pixel in the reference image data 102. In this example, 35 of the 36 comparisons will result in no error being identified as the two corresponding pixels are identical. However, when pixel 103a is compared to pixel 103b, a discrepancy will be identified between the two colour values which will be determined as an error in the image rendering technique.

Each comparison between corresponding pixels may involve determining whether there is a difference between the colour values of the respective pixels and if there is a difference, comparing that difference to a threshold value. This comparison may be performed across one or more of the channels of the colour space the colour of the pixel is expressed in. In some examples, if this difference is greater than the threshold value for at least one colour channel, the generated colour value for that pixel is identified as erroneous. According to other examples, the difference must be greater than the threshold difference across all of the colour channels in order that the rendered pixel is identified as being erroneous.

The threshold difference may be zero or non-zero. The threshold difference may be known as a tolerance. In other words, it may be that not only identical pixels are deemed "non-erroneous" (i.e. acceptable) but that pixels which have similar colour values (less than the threshold difference, or "within the tolerance") are deemed to have been correctly rendered. However, it has been found that rendered pixels which differ from their corresponding reference pixels for acceptable reasons, e.g. due to floating point rounding inaccuracies, are often incorrectly identified as erroneous using this approach.

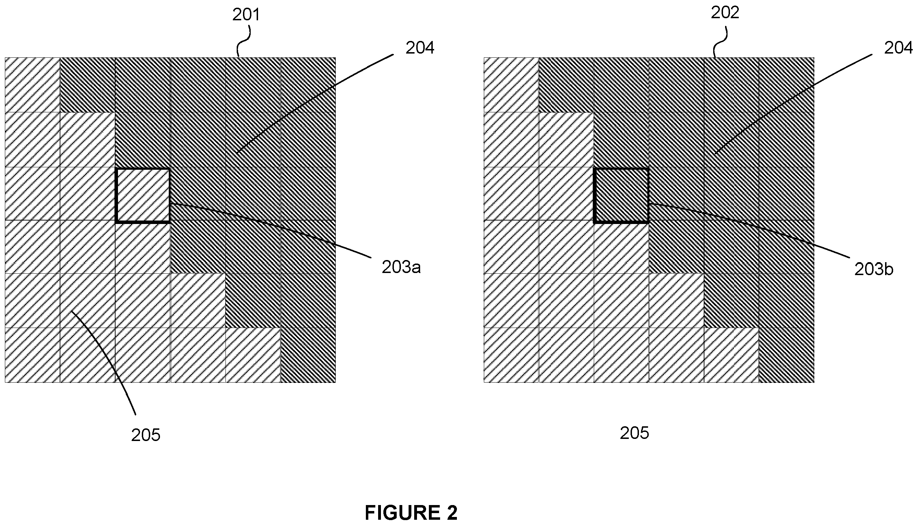

Figure 2 illustrates another block of image data 201 generated using an image rendering technique and a block of reference image data 202. Both blocks of image data are illustrated as being 6x6 blocks of pixels but according to other examples may comprise any number of pixels. Figure 2 shows that the generated image data 201 is identical to the reference image 202 except for pixel 203a/b.

The block of image data 201 in figure 2 represents a boundary (or "edge") between two colours 204 and 205. For example, the image may represent the boundary between a first object 204 having a first colour and a second object 205 having a second different colour. In the reference image data 202, pixel 203b has the colour of the first object 204 such that it appears to be part of the first object 204. In the generated image data 201, pixel 203a has the colour of the second object 205 such that it appears to be part of the second object 205.

It is not uncommon at boundaries between different colours, such as the example of figure 2, that the difference between a pixel in the rendered image data and its corresponding pixel in the reference image data is greater than the threshold difference due to differences in floating point rounding, even if the image rendering technique has been performed correctly. The colour value of pixel 203a in figure 2 has been generated differently to the equivalent reference pixel 203b. Thus, according to known techniques, where this difference exceeds the threshold difference, pixel 203b will be determined to be erroneous (i.e. not acceptable). However, despite this difference, it will be appreciated that the overall impression given to the viewer by the generated image data 201 is the same as that of reference image data 202, particularly where the blocks of image data seen in figure 2 form part of larger images. Using conventional techniques, a human operator is required to visually determine that the boundary has been rendered correctly (to the human eye) i.e. that pixel 203a should not be deemed erroneous or not acceptable. The present invention looks to automate this process.

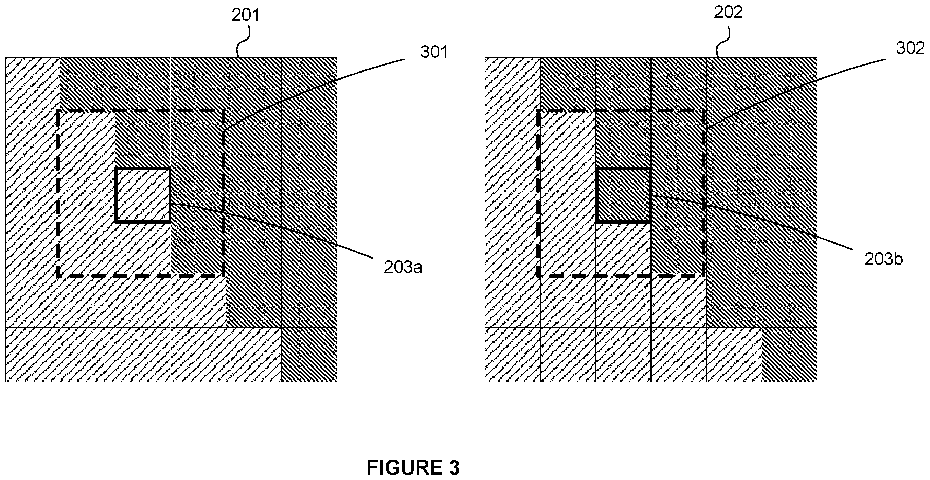

Figure 3 illustrates the same block of generated image data 201 and reference image data 202. Figure 3 also illustrates a group of pixels 301 which neighbour the pixel 203a and a group of pixels 302 which neighbour the pixel 203b. As previously discussed, using known techniques, determining a difference between pixel 203a and its corresponding pixel 203b in the reference image data 202 will result in a determination that the pixel is erroneous because the difference exceeds a threshold difference.

The present invention involves performing further processing on the two blocks of image data to determine whether that difference is likely to be due to a floating point rounding inaccuracy. Where it is determined that the difference is likely to be due to a floating point rounding inaccuracy, the pixel is classified as "acceptable". Where it is not determined that the difference is due to a floating point rounding inaccuracy and is therefore likely to be due to an error in the image rendering process, the pixel is classified as "not acceptable". As previously explained, a pixel deemed "not acceptable" may then be investigated further by the designer of the processing unit to determine its cause to improve the image rendering process.

To determine whether pixel 203a should be deemed acceptable or not acceptable, the present approach involves analysing at least one of the group of pixels 301 neighbouring pixel 203a and the group of pixels 302 neighbouring pixel 203b to determine whether the colour value of the pixel 203a is as a result of a floating point rounding inaccuracy. In the example seen in figure 3, the group of neighbouring pixels 301 is a 3x3 block of pixels having pixel 203a as the central pixel. The group of neighbouring pixels 302 is a 3x3 block of pixels having pixel 203b as the central pixel. However, according to other examples, the group of neighbouring pixels may be any number of pixels. In the example seen in figure 3, the group of neighbouring pixels take the form of a square of pixels, but according to other examples may be arranged in a different configuration.

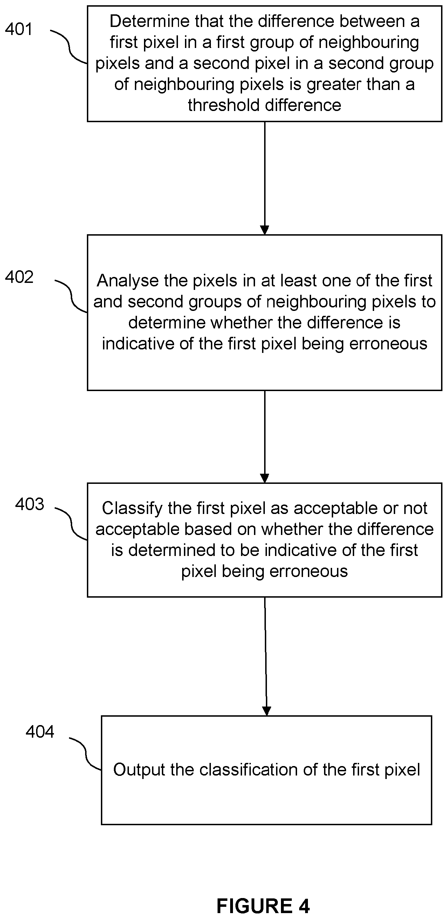

Figure 4 illustrates a method of classifying a first pixel in a first group of neighbouring pixels as acceptable or not acceptable with respect to a second pixel in a second group of neighbouring pixels. The method involves determining whether a difference between the first pixel and the second pixel is greater than a threshold difference. The determination of whether a difference between the first pixel and the second pixel exceeds a threshold difference may be made for a single colour channel or for multiple or all colour channels. This will apply equally to other thresholds described below. For example, for image data expressed in a colour space having four channels e.g. "RGBA", each pixel may have an 8-bit value in each of the colour channels, such that each pixel is represented with 32 bits. As example, an 8-bit integer value may represent a decimal value in a range from 0 to 255. Determining whether a difference between the first pixel and the second pixel is greater than a threshold difference may require determining that the difference between the 8 bit value corresponding to a single channel e.g. the "R" channel for the first pixel and that of the second pixel is greater than a threshold difference, for example 2. Alternatively, determining whether a difference between the first pixel and the second pixel is greater than a threshold difference may require determining that a sum of the differences between the 8 bit colour values corresponding to each of the four channels for the first pixel and that the respective colour values of the second pixel is greater than a threshold difference, for example 4. It will be appreciated that other values for the threshold difference may be used.

At step 401 it is determined that the difference between a first pixel in a first group of neighbouring pixels and a second pixel in a second group of neighbouring pixels is greater than the threshold difference. In response to determining that the difference between the first pixel and the second pixel is greater than the threshold difference, at step 402 the method involves analysing the pixels in at least one of the first and second groups of neighbouring pixels to determine whether the difference is indicative of the first pixel being erroneous. At step 403, the method involves classifying the first pixel as acceptable or not acceptable based on whether the difference is determined to be indicative of the first pixel being erroneous. At step 404, the classification of the first pixel is output.

In other words, the method involves considering the pixels surrounding the central pixel in one or both of the groups of neighbouring pixels in the generated and reference image data in order to determine whether a difference between the corresponding pixels is indicative of the difference being due to a floating point rounding inaccuracy. Step 402 may be performed in a variety of different ways which all result in an output classification of the first pixel.

Corresponding pixels are pixels which have the same position relative to the block of pixels in which they are found. For example, in figure 3, pixels 203a and 203b are corresponding pixels as they are located in the same position within the respective block of pixels in which they are found.

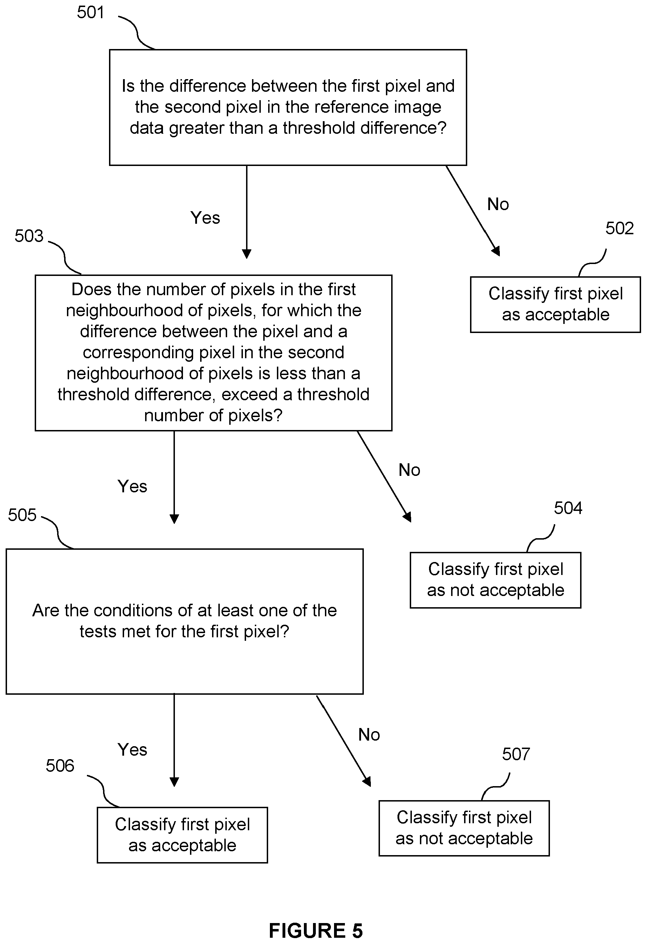

Figure 5 illustrates an example of a method which can be performed in order to classify a first pixel as acceptable or not acceptable. The method involves first determining whether a difference between the first pixel in generated image data and a corresponding second pixel in reference image data is greater than a threshold difference (step 501). If it is determined that the difference is less than the threshold difference, the first pixel is classified as acceptable (step 502). As previously discussed, using conventional techniques, determining that the difference between the first pixel and the second pixel is greater than the threshold difference will result in a determination that the pixel is erroneous, i.e. not acceptable. However, according to the method seen in figure 5, if it is determined that the difference between the first pixel and the second pixel is greater than the threshold difference, the method involves performing further processing on at least one of the two blocks of image data to determine whether that difference is indicative of the first pixel being erroneous.

As explained with respect to figure 3, in order to make this determination, the present approach takes into account a group of pixels which neighbour the first pixel (a first group of neighbouring pixels) and/or a corresponding group of pixels which neighbour the second pixel (a second group of neighbouring pixels). In figure 3, the first group of neighbouring pixels are the 3x3 block of pixels 301 and the second group of neighbouring pixels are the 3x3 block of pixels 302. As mentioned above, the first and second groups of neighbouring pixels can take any shape or size. The first and second groups of neighbouring pixels may take the same shape and size as one another and may be positioned equivalently with respect to the first and second pixels, respectively. Returning to the method of figure 5, before any determinations are made based on analysis of the first and/or second groups of neighbouring pixels, the method of figure 5 involves determining whether pixels near the first pixel have been correctly rendered. This determination may be made based on the pixels that are in the first group of pixels (301) or may be made based on a larger number of pixels which are near the first pixel (referred to herein as a region of pixels or neighbourhood of pixels).

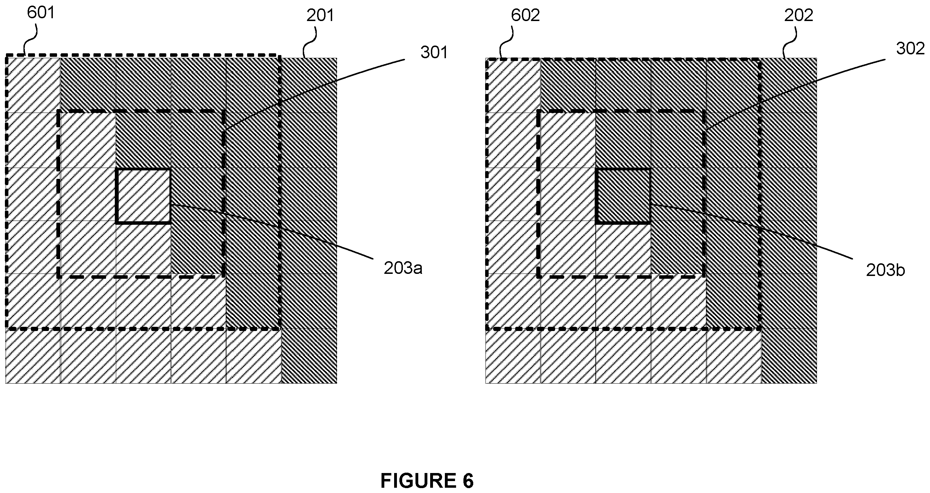

Figure 6 illustrates the same block of generated image data 201 and reference image data 202. Figure 6 also illustrates the first group of pixels 301 which neighbour the pixel 203a and the second group of pixels 302 which neighbour the pixel 203b. Figure 6 also illustrates a first region (i.e. neighbourhood) of pixels 601 which includes the first pixel 203a and the first group of neighbouring pixels 301. Figure 5 also shows a second region of pixels 602 which includes the second pixel 203b and the second group of neighbouring pixels 302. In this example, the first region of pixels 601 includes and extends beyond the first group of neighbouring pixels 301. The second region of pixels 602 includes and extends beyond the second group of neighbouring pixels 302. According to other examples, the first region 601 is the first group of neighbouring pixels 301 and the second region 602 is the second group of neighbouring pixels 302.

Returning to the method of figure 5, the method broadly involves determining whether the first region of pixels in the generated image data is similar enough to the second region of pixels in the reference image data that pixels in those regions can be used in the determination of whether the first pixel is acceptable or not. Specifically, step 503 of the method involves determining a number of pixels in the first region, for which the difference between the pixel and a corresponding pixel in the second region is less than the threshold difference and determining whether that number of pixels exceeds a threshold number of pixels. Step 503 therefore involves determining, for each pixel in the first region 601, a difference between the pixel and a corresponding pixel in the second region 602 and whether the difference between the pixel and the corresponding pixel is greater than the threshold difference. The threshold difference in this example is the same as the threshold difference used as part of step 501. According to other examples, the threshold difference may be a different value in different steps of the method. Step 503 further comprises calculating the number of pixels in the first region for which the difference between the pixel and the corresponding pixel is less than the threshold difference and determining whether that number of pixels is greater than a threshold number of pixels. A determination that the number of pixels is greater than the threshold number of pixels indicates that the pixels surrounding the first pixel 203a have been rendered accurately and therefore that these pixels can be relied on for further steps of the method.

Figure 5 illustrates that if at step 503 it is found that the number of pixels in the first region of pixels, for which the difference between the pixel and a corresponding pixel in the second region of pixels is less than a threshold difference, does exceed a threshold number of pixels, then the method moves onto step 505. For example, figure 6 shows that all of the pixels in the first region of pixels 601 in the generated image data 201 are the same as their corresponding pixels in the second region of pixels 602 in the reference image data 202, except pixel 203a. Thus, if step 503 were performed with respect to the generated image data shown in figure 6, depending on the selected value for the threshold difference, the result would likely be that the number of pixels in the first region for which the difference between the pixel and a corresponding pixel in the second region of pixels is less than a threshold difference, does exceed a threshold number of pixels, and the method would move to step 505.

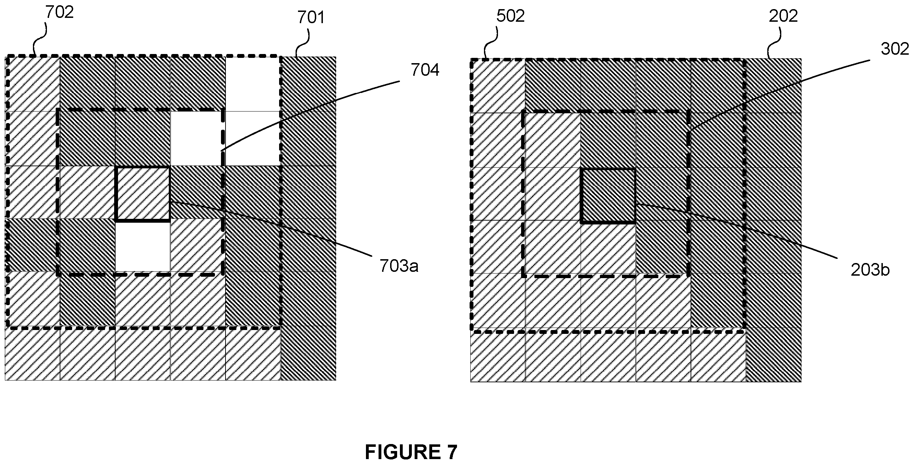

However, if it is determined that the threshold number of pixels is not met, this indicates that the pixels in the first region should not be relied on for further steps of the method. Therefore, as shown in figure 5, at step 504 the first pixel is classified as not acceptable. Figure 7 illustrates a block of generated image data 701 and the same reference image data 202. This figure shows that of the 24 pixels in the first region 702 (excluding pixel 703a), 9 of these pixels have been rendered so as to have a colour value that is different to their corresponding pixels in the second region 502 in reference image data 202. Thus, if step 503 were performed with respect to the generated image data 701 shown in figure 7 depending on the selected value for the threshold difference, the result would likely be that the number of pixels in the first region for which the difference between the pixel and a corresponding pixel in the second region of pixels is less than a threshold difference, does not exceed a threshold number of pixels, and the method would move to step 504. At step 504 the first pixel is classified as not acceptable.

As seen in figure 5, at step 505, one or more tests are performed to determine whether the requirements of at least one of those tests are met for the first pixel. Each test involves analysing the pixels in at least one of the first and second groups of neighbouring pixels (in the generated image data and reference image data, respectively). Figure 5 shows that if the conditions of at least one test is met, the method proceeds to step 506 and classifies the first pixel as acceptable. In other words, if the requirements of at least one test is met, this is indicative that the difference between the first pixel and its corresponding pixel in the reference image data (the second pixel) is due to a floating point rounding inaccuracy and that the pixel has not been rendered erroneously. If the requirements of none of the tests are met, the method proceeds to step 507 and the pixel is classified as not acceptable. In other words, if none of the conditions of the tests are met, this is indicative that the discrepancy in colour value between the first and second pixels is due to an error in the image rendering process and is not due to a floating point rounding inaccuracy.

The following tests 1 to 5 can be performed in order to determine a classification of the pixel as acceptable or not acceptable as explained in more detail below. Any number of these tests may be performed on the generated image data and the tests may be performed in any order. For example, if test 1 is performed and its requirements are not met, the method may proceed to perform test 2. The method may involve performing different tests until the requirements of one of those tests are met. Alternatively, if one test is performed (e.g. test 1) and its requirements are met, the method may not perform any more tests and proceed straight to step 506.

### Test 1

Returning to the example block of generated image data 201 in figure 6, test 1 involves determining whether the difference between the first pixel 203a in the generated image data 201 and the second pixel 203b in the reference image data 202 is indicative of the first pixel 203a being erroneous by comparing the first pixel 203a to each pixel in the second group of neighbouring pixels 302 of the reference image data 202. Specifically, the test involves determining the difference between the first pixel and each pixel in the second group of neighbouring pixels and determining whether any of those differences are less than the threshold difference. According to one example, if the difference between the first pixel and at least one of the pixels in the second group of neighbouring pixels is less than the threshold difference, then the first pixel is classified as acceptable. In other words, if the difference between the first pixel and at least one of the pixels in the second group of neighbouring pixels is less than the threshold difference, this indicates that it is plausible that the difference is due to a floating point rounding inaccuracy.

Thus, according to one example, in order for the condition of test 1 to be met, the difference between the first pixel and at least one of the pixels in the second group of neighbouring pixels must be less than the threshold difference.

### Test 2

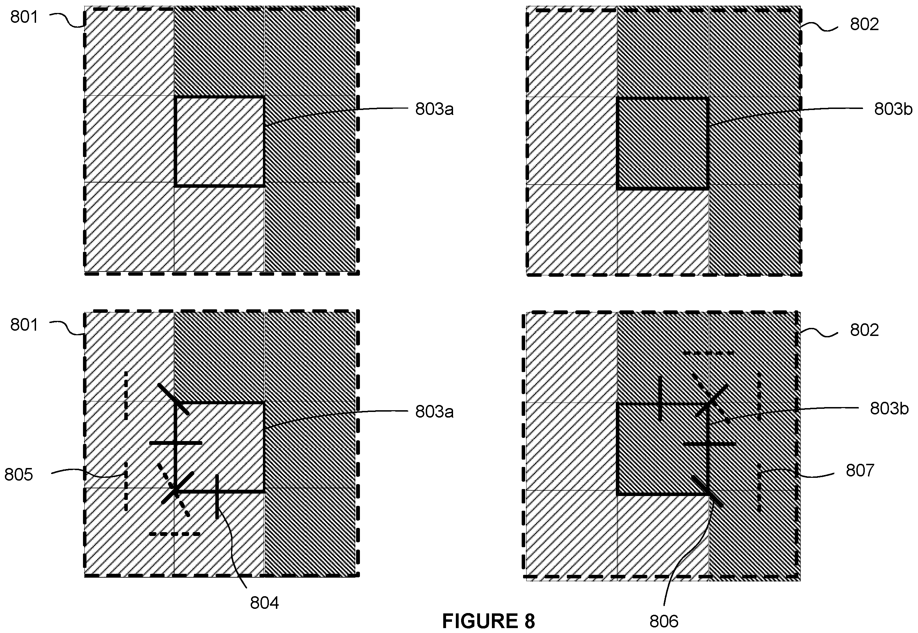

Figure 8 illustrates a first group of neighbouring pixels 801 which form part of a block of generated image data. The first group of neighbouring pixels 801 centres around first pixel 803a. Figure 8 also shows a second group of equivalent neighbouring pixels 802 which form part of a block of reference image data. The second group of neighbouring pixels 802 centres around a second pixel 803b. According to one example, test 2 is performed using the first and second group of neighbouring pixels 801 and 802 to determine whether the first pixel 803a should be classified as acceptable or not acceptable.

Test 2 broadly looks to decide whether the first pixel 803a is located on the boundary (i.e. the edge) between two objects and whether it is plausible that the pixel could belong to the object on the other side of the boundary. A single pixel appearing to be part of an object on the other side of a boundary will not create a different overall impression for the viewer of the generated image data and so the pixel can be classified as acceptable. To determine whether this is the case, test 2 involves forming connections (herein referred to as primary connections, illustrated as a solid line in figure 8 e.g. 804, 806) between the first pixel 803a and any adjacent pixels in the first group of neighbouring pixels 801 which have a similar colour value. A pixel which is adjacent to the first pixel is any pixel which shares an edge or corner with the first pixel. The first pixel and a pixel which is adjacent to the first pixel are referred to herein as adjacent pixels. In the example seen in figure 8, because the first group of neighbouring pixels is a 3x3 block of pixels centred on the first pixel, all of the pixels in the first group of neighbouring pixels are adjacent to the first pixel. However, in other examples, the first group of neighbouring pixels may take another form, for example may include a larger number of pixels, in which case not all the pixels in the first group of neighbouring pixels will be adjacent to the first pixel. Test 2 also involves forming primary connections between the second pixel 803b and any adjacent pixels in the second group of neighbouring pixels 802 which have a similar colour value.

In the first group of neighbouring pixels, pixels which are connected to the first pixel 803a by primary connections (i.e. primarily connected pixels) are tested against adjacent pixels (which may or may not be connected to the first pixel) to determine whether each primarily connected pixel has a similar colour value to its adjacent pixels. Connections (herein referred to as secondary connections, illustrated as a dashed line e.g. 805) are formed between a primarily connected pixel and any pixel adjacent to it (excluding the first pixel 803a) which has a similar colour value.

In the second group of neighbouring pixels, pixels which are connected to the second pixel 803b by primary connections (i.e. primarily connected pixels) are tested against adjacent pixels (which may or may not be connected to the second pixel) to determine whether each primarily connected pixel has a similar colour value to its adjacent pixels. Secondary connections are formed between a primarily connected pixel and any pixel adjacent to it (excluding the second pixel 803b) which has a similar colour value.

Test 2 involves determining a difference between the first pixel 803a and each adjacent pixel in the first group of neighbouring pixels 801 and determining whether each difference is greater than a threshold difference. The threshold difference may be the same value or a different value to the threshold difference previously mentioned. When the difference between the first pixel 803a and an adjacent pixel in the first group of neighbouring pixels is less than the threshold difference (i.e. the two pixels have a similar colour value), a primary connection 804 is formed between the two pixels. Figure 8 shows that four primary connections are formed in the first group of neighbouring pixels 801.

The same steps are performed with respect to the reference image data. Test 2 involves determining a difference between the second pixel 803b and each adjacent pixel in the second group of neighbouring pixels 802 and determining whether each difference is greater than the threshold difference. When the difference between the second pixel 803b and an adjacent pixel in the second group of neighbouring pixels is less than the threshold difference (i.e. that the two pixels have a similar colour value), a primary connection 806 is made between the two pixels. Figure 8 shows that four primary connections are formed in the second group of neighbouring pixels 802.

Figure 8 illustrates a simple example of applying Test 2 in which, in each group of neighbouring pixels, each of the pixels which are connected to the central pixel (the primarily connected pixels) are the same colour as each other. Therefore, secondary connections are formed between each primarily connected pixel and each adjacent primarily connected pixel.

All of the primarily connected pixels in figure 8 have been illustrated as being of a single colour for clarity, however according to other less simple examples, primarily connected pixels may not all be similar in colour to one another. In such situations, two adjacent pixels that are each connected to the central pixel by a primary connection, may not be connected to one another by a secondary connection. It may be the case that one of these pixels has a colour value that is higher than the colour value of the central pixel (by less than the threshold difference) and the other of these pixels has a colour value that is lower than the colour value of the central pixel (by less than the threshold difference). In this case, both pixels would be connected to the central pixel by a primary connection, however the difference between the colour value of the two primarily connected pixels could be greater than the threshold difference such that the two primarily connected pixels would not be connected to each other by a secondary connection.

Test 2 also involves, in the first group of neighbouring pixels, determining a difference between each primarily connected pixel and its adjacent pixels (except the first pixel 803a). In other words, each primarily connected pixel in the first group of neighbouring pixels is compared to each other pixel with which it shares an edge or corner to determine the difference between the colour values of the pixels. It is then determined for each pair of adjacent pixels whether the colour difference between the pixels is greater than the threshold difference. When the difference between a primarily connected pixel and an adjacent pixel in the first group of neighbouring pixels is less than the threshold difference (i.e. the two pixels have a similar colour value), a secondary connection 805 is made between the two pixels. Figure 8 shows that four secondary connections are formed in the first group of neighbouring pixels 801.

The same steps are performed with respect to the reference image data. Test 2 involves, in the second group of neighbouring pixels 802, determining a difference between each primarily connected pixel and its adjacent pixels (except the second pixel 803b) and determining, for each pair of adjacent pixels, whether the colour difference between the pixels is greater than the threshold difference. When the difference between a primarily connected pixel and an adjacent pixel in the second group of neighbouring pixels is less than the threshold difference (i.e. the two pixels have a similar colour value), a secondary connection 807 is made between the two pixels. Figure 8 shows that four secondary connections are formed in the second group of neighbouring pixels 802.

Once the primary and secondary connections have been formed in the first and second groups of neighbouring pixels, for each group of neighbouring pixels, the total number of pixel connections is calculated. The total number of pixel connections for each group of neighbouring pixels is equal to the sum of the primary connections and secondary connections formed in that group of neighbouring pixels. A set of four conditions must be then met in order to determine that the first pixel 803a should be classified as acceptable. In order that the first pixel 803a is classified as acceptable, [1] the number of primary connections (804) formed in the first group of neighbouring pixels must be greater than a first connection threshold, [2] the number of primary connections (806) formed in the second group of neighbouring pixels must be greater than the first connection threshold, [3] the total number of connections formed in the first group of neighbouring pixels must be greater than a second connection threshold and [4] the total number of connections formed in the second group of neighbouring pixels must be greater than the second connection threshold. If these four conditions [1-4] are met, this indicates that the first pixel 803a is located on the boundary between two objects and therefore that it is plausible that the pixel could belong to the object on the other side of the boundary. Thus, if the conditions of test 2 are met, this is indicative that the difference between the first pixel 803a and second pixel 803b is due to a floating point rounding inaccuracy. Therefore, if the conditions of test 2 are met, the first pixel is classified as acceptable. This example requires that all four conditions [1-4] are met in order that the first pixel is classified as acceptable. According to other examples, it may be that only a subset of these conditions are required to be met to classify the pixel as acceptable.

According to another example, a different set of four conditions must be met in order to determine that the first pixel 803a should be classified as acceptable. For example, condition [3] may be that the number of secondary connections (805) formed in the first group of neighbouring pixels must be greater than a second connection threshold and condition [4] may be that the number of secondary connections (807) formed in the second group of neighbouring pixels must be greater than the second connection threshold. The test may alternatively require only that the number of primary and secondary connections exceed the first and second connection thresholds for one of the first and second groups of neighbouring pixels.

This example requires that all four conditions [1-4] are met in order that the first pixel is classified as acceptable. According to other examples, it may be that only a subset of these conditions are required to be met to classify the pixel as acceptable.

According to a further example, the number of connected pixels in each group of neighbouring pixels may be used, instead of the number of connections formed, in order to determine whether the first pixel should be classified as acceptable.

As previously mentioned, if the conditions of test 2 are not met, the first pixel cannot be classified as acceptable and the method may involve performing another test on the generated image data, for example the method may then perform test 3.

### Test 3

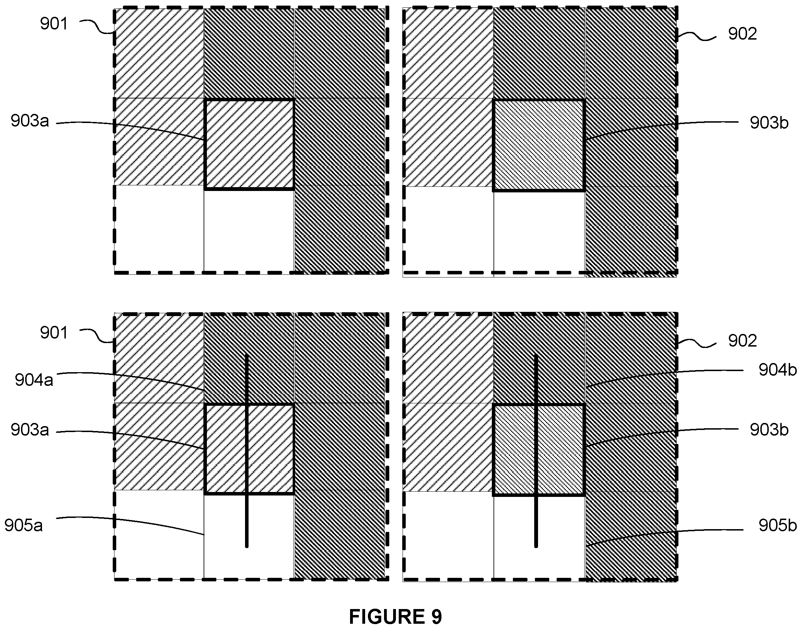

Figure 9 illustrates a first group of neighbouring pixels 901 which form part of a block of generated image data. The first group of neighbouring pixels 901 centres around first pixel 903a. Figure 9 also shows a second group of equivalent neighbouring pixels 902 which form part of a block of reference image data. The second group of neighbouring pixels 902 centres around a second pixel 903b. According to one example, test 3 is performed using the first and second group of neighbouring pixels to determine whether the first pixel 903a should be classified as acceptable or not acceptable.

Test 3 broadly looks to decide whether the first pixel 903a is a blend of two of its adjacent pixels. In other words, test 3 determines whether the first pixel 903a forms a gradient with two adjacent pixels. If a floating point rounding inaccuracy has occurred resulting in the first pixel having a slightly different value than the reference image data but still forming a gradient with adjacent pixels, the overall appearance of the generated image data to the viewer will be the same such that the pixel can be classified as acceptable. To determine whether this is the case, test 3 involves identifying pairs of pixels which are adjacent to and located on opposite sides of the first pixel (i.e. which flank the first pixel) and determining whether the colour value of the first pixel lies between the colour values of the respective flanking pixels i.e. it forms a gradient with the flanking pixels. Flanking pixels may share an edge with the first pixel. Flanking pixels may be located diagonally with respect to the first pixel i.e. they may share a corner with the first pixel.

With respect to the first group of neighbouring pixels 901, test 3 involves, for each pair of pixels in the first group of neighbouring pixels which flank the first pixel 903a (i.e. for each pair of flanking pixels), comparing the colour value of each flanking pixel to the colour value of the first pixel. Figure 9 illustrates one set of flanking pixels, first flanking pixel 904a and second flanking pixel 905a (indicated by a solid line). For all pairs of flanking pixels in the first group of neighbouring pixels, test 3 involves determining whether the colour value of the first pixel 903a lies between the colour value of the first flanking pixel and the colour value of the second flanking pixel. Figure 9 illustrates that the colour of first pixel 903a lies between the colour value of the first flanking pixel 904a and the colour value of second flanking pixel 905a.

The same steps are performed with respect to the reference image data. With respect to the second group of neighbouring pixels 902, test 3 involves, for each pair of pixels in the second group of neighbouring pixels which flank the second pixel 903b (i.e. for each pair of flanking pixels), comparing the colour value of each flanking pixel to the colour value of the second pixel. Figure 9 illustrates one set of flanking pixels, first flanking pixel 904b and second flanking pixel 905b (indicated by a solid line). For all pairs of flanking pixels in the second group of neighbouring pixels, test 3 involves determining whether the colour value of the second pixel 903b lies between the colour value of the first flanking pixel and the colour value of the second flanking pixel. Figure 9 illustrates that the colour of second pixel 903b lies between the colour value of the first flanking pixel 904b and the colour value of second flanking pixel 905b.

The positions of the flanking pixels identified in the first group of neighbouring pixels relative to the first pixel may be the same as the positions of the flanking pixels identified in the second group of neighbouring pixels relative to the second pixel. In other words, the flanking pixels identified in the first group of neighbouring may be corresponding pixels to the flanking pixels identified in the second group of neighbouring pixels. According to other examples, the positions of the flanking pixels identified in the first group of neighbouring pixels relative to the first pixel may be different to the positions of the flanking pixels identified in the second group of neighbouring pixels relative to the second pixel. The flanking pixels identified in the first group of neighbouring pixels may have a different configuration to the flanking pixels identified in the second group of neighbouring pixels.

In order for the first pixel 903a to be classified as acceptable using test 3, two conditions must be met. It must be the case that [1] the first group of neighbouring pixels 901 includes at least one pair of flanking pixels for which the colour value of the first pixel lies between the respective colour values of the first and second flanking pixels and that [2] the second group of neighbouring pixels 902 includes at least one pair of flanking pixels for which the colour value of the second pixel lies between the respective colour values of the first and second flanking pixels. If both of these conditions are met, this is indicative that in the reference image data, the second pixel forms a gradient with a pair of flanking pixels and that the first pixel has been rendered such that it forms a colour gradient with a pair flanking pixels such that the overall impression given to the user by the rendered image data is unchanged.

Therefore, if the conditions of test 3 are met, this indicates that the difference between the first pixel 903a and second pixel 903b is due to floating point rounding inaccuracies and the first pixel is classified as acceptable.

Determining whether the colour value of a pixel lies between the colour value of a first flanking pixel and the colour value of a second flanking pixel involves performing this determination across a plurality of the channels of the colour space the colour value of the pixel is expressed in. According to one example, the determination is performed across all channels of the colour value. Thus, in order that the conditions of test 3 are met, it must be the case that the first group of neighbouring pixels 9801 includes at least one pair of flanking pixels for which the colour value of the first pixel lies between the respective colour values of the first and second flanking pixels for all colour channels and that the second group of neighbouring pixels 9802 includes at least one pair of flanking pixels for which the colour value of the second pixel lies between the respective colour values of the first and second flanking pixels for all colour channels.

This example requires that both conditions [1] and [2] are met in order that the first pixel is classified as acceptable. According to other examples, it may be that only one of these conditions are required to be met to classify the pixel as acceptable.

According to other examples of test 3, for example if we assume colours are three-dimensional, for image data expressed in a colour space using 3 colour channels e.g. RGB, an axis-aligned rectangular box can be defined as having respective flanking pixels at opposite corners of the box. Taking the first group of neighbouring pixels as an example, test 3 may be passed if the colour of the first pixel falls inside the axis-aligned rectangular box i.e. if the colour value of the first pixel lies between the respective colour values of the first and second flanking pixels for all colour channels. For a true gradient, the colour value of the first pixel will fall within the axis-aligned box and will be positioned along a line joining the two colour values of the flanking pixels at opposite corners of the box. The test could involve a condition that the colour value of the first pixel must be within a certain distance of this line in order that the first pixel is classified as acceptable. The required distance from the line may depend on the distance of the colour value from an endpoint of the line (i.e. from one of the colour values of the flanking pixels). The same test could be applied to the second group of neighbouring pixels.

As previously mentioned, if the conditions of test 3 are not met, the first pixel cannot be classified as acceptable and the method may involve performing another test on the generated image data, for example test 4.

### Test 4

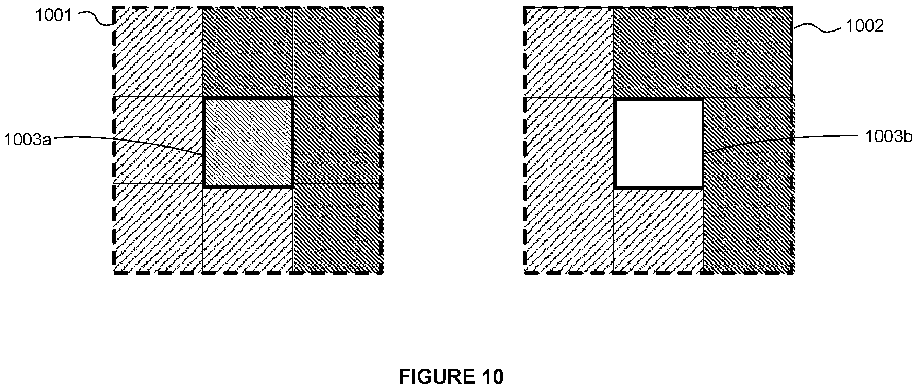

Figure 10 illustrates a first group of neighbouring pixels 1001 which form part of a block of generated image data. The first group of neighbouring pixels 1001 centres around first pixel 1003a. Figure 10 also shows a second group of equivalent neighbouring pixels 1002 which form part of a block of reference image data. The second group of neighbouring pixels 1002 centres around a second pixel 1003b. According to one example, test 4 is performed using the first and second group of neighbouring pixels to determine whether the first pixel 1003a should be classified as acceptable or not acceptable.

The aim of test 4 is to decide whether both the first pixel 1003a and the second pixel 1003b are significantly different colours to all of their surrounding pixels (the rest of the pixels in the first group of neighbouring pixels and second group of neighbouring pixels, respectively.) Test 4 involves, for the first group of neighbouring pixels 1001, comparing the colour value of the first pixel 1003a to the colour value of each pixel in the first group of neighbouring pixels and determining whether the colour value of the first pixel is greater or less than the colour value of all of the pixels in the first group of neighbouring pixels i.e. is the first pixel much brighter or darker than all the other pixels in the first group of neighbouring pixels. Test 4 also involves performing the same steps with respect to the second group of neighbouring pixels 1002. Test 4 involves, for the second group of neighbouring pixels 1002, comparing the colour value of the second pixel 1003b to the colour value of each pixel in the second group of neighbouring pixels and determining whether the colour value of the second pixel is greater or less than the colour value of all of the pixels in the second group of neighbouring pixels i.e. is the second pixel much brighter or darker than all the other pixels in the second group of neighbouring pixels.

Test 4 also involves determining whether the difference between the first pixel 1003a and the second pixel 1003b is less than a threshold difference. The threshold difference is greater than the threshold difference previously described with respect to steps 501 and 503 of the method.

As previously explained, each comparison between corresponding pixels in the generated and reference image data may involve comparing the pixels across one or more of the channels of the colour space the colour of the pixel is expressed in. According to the example test 4 seen in figure 10, the colour value of the first pixel may be determined as being greater than the colour value of another pixel in the group of neighbouring pixels if the values in all the colour channels for the first pixel are greater than the respective values in all the colour channels for the other pixel. Determining that the colour value of the first pixel is less than the colour value of another pixel therefore requires determining that the values in all the colour channels for the first pixel are less than the respective values in all colour channels in the other pixel.

Thus, in order for the first pixel 1003a to be classified as acceptable using test 4, three conditions must be met. These are that [1] the colour value of the first pixel 1003a is greater than the colour value of all of the pixels in the first group of neighbouring pixels for all channels in the colour values, [2] the colour value of the second pixel 1003b is greater than the colour value of all of the pixels in the second group of neighbouring pixels for all channels in the colour values and [3] that the difference between the first pixel and the second pixel is less than the threshold difference. Alternatively, the three conditions are that [1] the colour value of the first pixel 1003a is less than the colour value of all of the pixels in the first group of neighbouring pixels for all channels in the colour values, [2] the colour value of the second pixel 1003b is less than the colour value of all of the pixels in the second group of neighbouring pixels for all channels in the colour values and [3] that the difference between the first pixel and the second pixel is less than the threshold difference.

According to other examples, test 4 may not require that conditions [1] and [2] are met across all the colour channels in which the colour value is expressed. For example, conditions [1] and [2] may only be required to be met for a luminance colour channel for image data expressed in a colour space having a luminance channel. If a different colour space is used which doesn't have a luminance channel, a luminance value for the pixel may be computed, for example using an appropriate colour space conversion matrix. As an example, for image data expressed in the RGBA colour space, test 4 may require that conditions [1], [2] and [3] are met only for the green ("G") channel for the pixels.

As a further example, conditions [1] to [3] may also be met if the colour value is equal to the respective threshold. Specifically, condition [1] requires that the colour value of the first pixel 1003a is greater than or equal to the colour value of all of the pixels in the first group of neighbouring pixels for all channels in the colour values, condition [2] requires that the colour value of the second pixel 1003b is greater than or equal to the colour value of all of the pixels in the second group of neighbouring pixels for all channels in the colour values and condition [3] is that the difference between the first pixel and the second pixel is less than the threshold difference. Alternatively, the three conditions are that [1] the colour value of the first pixel 1003a is less than or equal to the colour value of all of the pixels in the first group of neighbouring pixels for all channels in the colour values, [2] the colour value of the second pixel 1003b is less than or equal to the colour value of all of the pixels in the second group of neighbouring pixels for all channels in the colour values and [3] that the difference between the first pixel and the second pixel is less than or equal to the threshold difference. According to one implementation, the conditions of test 4 are met for image data expressed in a colour space having an alpha channel when conditions [1] to [3] are met for only for pixel values in the alpha channel of the image data.

According to further examples, one of tests 1 to 4 may be applied to only one of the generated image data and the reference image data and another one of tests 1 to 4 may be applied to the other of the generated image data and the reference image data. If the conditions of one test are met for the generated image data and the conditions of another test are met for the reference image data, the first pixel may be classified as acceptable.

### Test 5

For example, performing test 5 involves performing test 2 on one of the generated image data and the reference image data and performing test 3 on the other of the generated image data and the reference image data.

According to one example, in order for the requirements of test 5 to be fulfilled and the first pixel to be classified as acceptable, in the generated image data, the number of primary connections formed in the first group of neighbouring pixels must be greater than a first connection threshold and the total number of connections formed in the first group of neighbouring pixels must be greater than a second connection threshold and, in the reference image data, the second group of neighbouring pixels must include at least one pair of pixels flanking the second pixel for which the colour value of the second pixel lies between the respective colour values of the first and second flanking pixels. According to a further example, in order to classify the first pixel as acceptable, the conditions of test 3 must be met for the generated image data only and the conditions of test 2 must be met for the reference image data only.

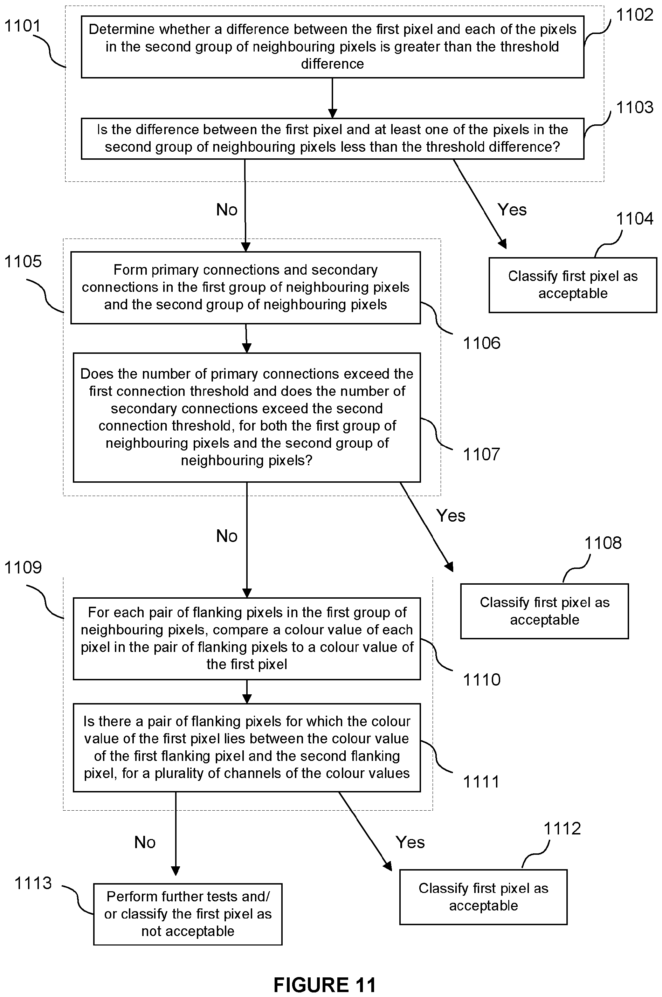

Figure 11 illustrates a method that may be performed as part of step 402 of the method of figure 4 or as part of step 505 of the method of figure 5. As previously explained, any number of tests 1 to 5 can be performed in any order to determine a classification of the pixel as acceptable or not acceptable. The method seen in figure 11 involves performing test 1, in some cases test 2 and in other cases tests 2 and 3.

At step 1101, the method involves performing test 1. Specifically, at step 1102, it is determined whether a difference between the first pixel and each of the pixels in the second group of neighbouring pixels is greater than the threshold difference. At step 1103 it is determined whether the difference between the first pixel and at least one of the pixels in the second group of neighbouring pixels is less than the threshold difference. If the answer is yes, the conditions of test 1 are met which indicates that the first pixel is not erroneous. The first pixel is classified as acceptable at step 1104. If the answer is no, the method proceeds to performing test 2 at step 1105. Specifically, at step 1106, primary connections and secondary connections are formed in the first group of neighbouring pixels and the second group of neighbouring pixels. At step 1107, it is determined whether the number of primary connections exceeds the first connection threshold and whether the total number of connections exceeds the second connection threshold, for both the first group of neighbouring pixels and the second group of neighbouring pixels. The total number of connections for the first and second groups of neighbouring pixels is determined as the sum of primary connections and secondary connections in the respective group of neighbouring pixels. If the answer is yes, the conditions of test 2 are met which indicates that the first pixel is not erroneous. The first pixel is classified as acceptable at step 1108. If the answer is no, the method proceeds to performing test 3 at step 1109. Specifically, at step 1110, for each pair of flanking pixels in the first group of neighbouring pixels, the colour value of each pixel in the pair of flanking pixels is compared to the colour value of the first pixel. At step 1111, it is determined whether there is a pair of flanking pixels for which the colour value of the first pixel lies between the colour value of the first flanking pixel and the second flanking pixel, for a plurality of colour channels. If the answer is yes, the conditions of test 3 are met which indicates that the first pixel is not erroneous. The first pixel is classified as acceptable at step 1112. If the answer is no i.e. if the requirements of test 3 are not met, the method may involve performing one or more further tests or the method may involve classifying the first pixel as not acceptable (step 1113).

The tests described require the comparison of several values to thresholds. It will be appreciated that the values of the various thresholds described may be chosen on an individual basis and may be adapted to specific applications. According to one example, for image data expressed in an RGBA colour space as previously described, the threshold difference used in step 501 may have a value of 4, the threshold number of pixels used in step 503 may have a value of 30, the threshold difference used as part of Test 2 may have a value of 30, the first connection threshold used as part of Test 2 may have a value of 2 and the second connection threshold used as part of Test 2 may have a value of 3. The threshold difference used as part of Test 4 may have a value of 50.

As mentioned above, it may be useful in other applications, for example in motion estimation and neural networks, to be able to identify differences between pixels that are not as a result of errors.

Some techniques for motion estimation, for example those used for frame rate conversion, involve determining the movement path of a first block of pixels (e.g. representing an object) through a scene across a series of frames. Conventional techniques for determining the path of a block of pixels involve comparing the block of pixels in a first frame to a plurality of other blocks of pixels (of the same size) in a second subsequent frame to determine which other block of pixels most closely resembles the block of pixels of the first frame. Once the most similar block of pixels has been identified, a motion vector between the two blocks can be found (which represents the movement path of the block of pixels between frames).

Determining which block of pixels in the second frame most closely resembles the first block of pixels in the first frame involves, for each of the plurality of blocks of pixels in the second frame, determining a metric indicative of a similarity between the block and the first block of pixels in the first frame. Once the metric has been calculated for each block of pixels in the second frame, the metric indicating the highest degree of similarity can be found and a motion vector between the two blocks of pixels can be determined.

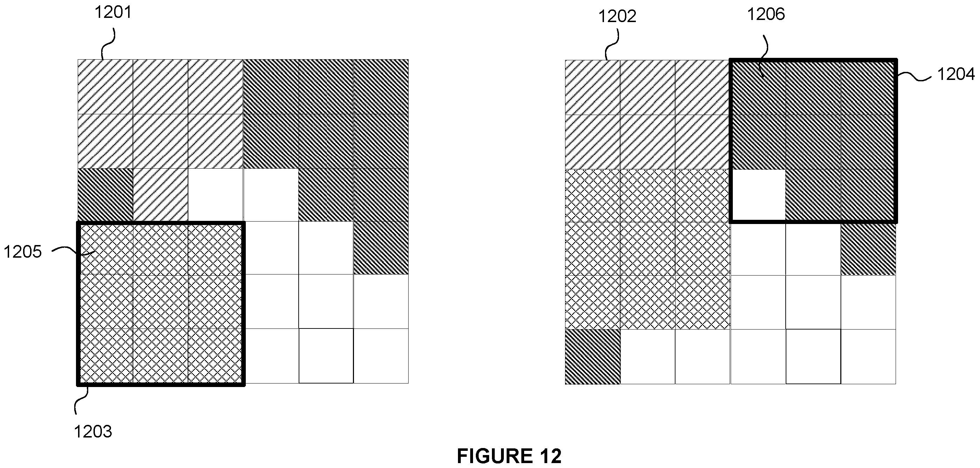

Figure 12 illustrates a first frame 1201 and a second frame 1202. In this example, the second frame occurs temporally after the first frame and each frame includes 36 pixels. The first frame 1201 includes a first block of pixels 1203. In this example, the first block of pixels is a 3x3 block of pixels. In order to determine a movement path of the block 1203 between the first frame 1201 and the second frame 1202, for a number of 3x3 blocks in the second frame, a metric is calculated which is indicative of the similarity between block 1203 and the respective block in the second frame. For example, block 1203 may first be compared to block 1204 in the second frame to determine a metric indicative of a similarity between blocks 1203 and 1204.

The metric indicative of a similarity between the two blocks is determined as a combination of terms based on the differences between corresponding pixels in the two blocks of pixels. Taking as an example the comparison between block 1203 and block 1204, the metric is determined as a combination of terms, where each term is based on the difference between each pixel in the block 1203 and its corresponding pixel in block 1204. The combination of terms could be a sum of terms, e.g. a sum of absolute differences or a sum of squared differences. Corresponding pixels are pixels which have the same relative position relative to the block of pixels in which they are found. For example, in figure 12, pixels 1205 and 1206 are corresponding pixels as they are both found in the top left position within the respective block of pixels 1203, 1204 in which they are found. Therefore, in the example seen in figure 12, one term of the metric will be determined based on the difference between pixel 1205 in block 1203 and its corresponding pixel 1206 in block 1204.

Since each term of the metric is based on the difference between corresponding pixels in the two blocks of pixels, the determined metric will be greater for two blocks which contain significantly different colour values than it would be for two blocks which appear quite similar. Thus, a lower value for the determined metric indicates a greater degree of similarity between the two blocks. A lower value therefore also indicates that the two blocks may represent the same object, for example that an object has moved from a position represented by the first block in the first frame to a position represented by the second block in the second frame.

It has been found for objects which have a movement path involving both translation and small amounts of rotation, that large pixel colour value differences can occur near the object's edge. Therefore, for two pixels in different frames which represent a part of the same object, when an object has rotated by a few degrees, this can result in the difference between the two corresponding pixels being determined as "large" despite the fact that they represent a part of the same object. Similar large differences may occur when the two frames are viewed from a slightly different camera angle, with slightly different zoom or transparency or when the object is illuminated by slightly different lightning (caused by direct or reflected rays).

These "large" differences contribute to the metric indicative of similarity between two blocks and therefore can skew the metric to also being "large" even in circumstances where the two blocks do represent the same (slightly rotated) object.

It is therefore desirable to exclude from the metric (or at least reduce) terms which may have a large value due to small object rotations. The techniques previously described to account for floating point rounding inaccuracies, for example using one or more of the tests 1 to 5, may also be used to determine that a difference between two corresponding pixels in sequential frames is likely to be due to a small object rotation. According to the present approach, once this likelihood is identified with respect to a particular term of the metric corresponding to a pair of corresponding pixels, the contribution of this term to the metric may be eliminated or otherwise reduced.

Therefore, each comparison of corresponding pixels performed as part of determining the metric indicative of similarity between the blocks may be performed using the techniques previously described, for example using one or more of tests 1 to 5.

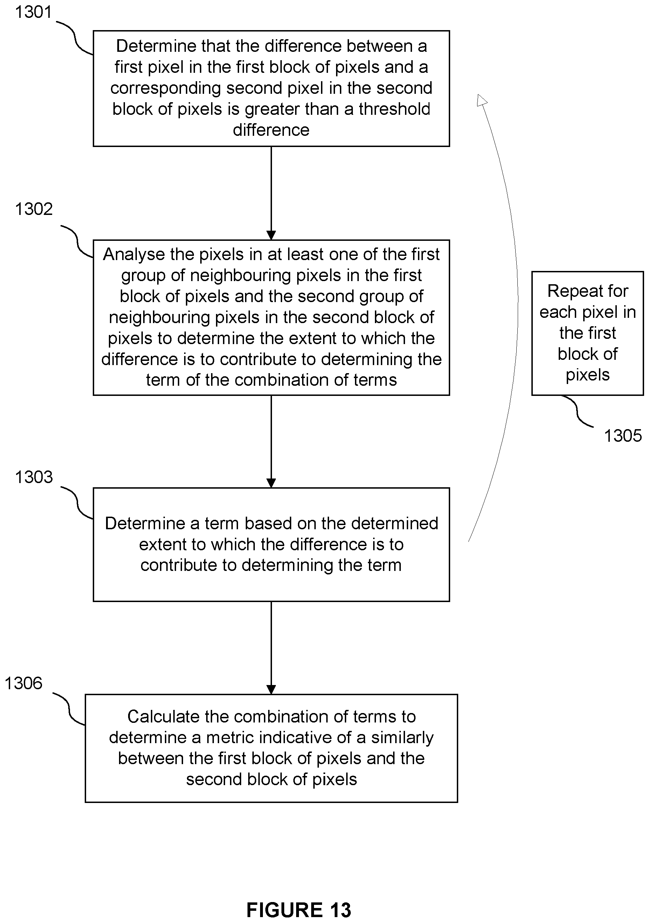

Figure 13 illustrates a method for determining a metric indicative of the similarity between blocks 1203 and 1204 once it has been found that the difference between a first pixel in the first block of pixels and a corresponding second pixel in the second block of pixels is greater than a threshold difference. At step 1301, it is determined whether the difference between a first pixel in the first block (e.g. pixel 1205) and a corresponding second pixel in the second block (e.g. 1206) is greater than a threshold difference. If it is determined that this difference is greater than the threshold difference, the method proceeds to step 1302. Thus, in response to determining that the difference between the first pixel and the second pixel is greater than a threshold difference, step 1302 involves analysing the pixels in at least one of a first group of neighbouring pixels in the first block of pixels and a second group of neighbouring pixels in the second block of pixels to determine an extent to which the difference is to contribute to determining the term of the combination of terms. In the example seen in figure 12, each block of pixels is a 3x3 block of 9 pixels. The group of neighbouring pixels in each frame may therefore be the same pixels as the block of pixels i.e. block 1203 is also the first group of neighbouring pixels. According to other examples, the first block of pixels contains a larger number of pixels and the first group of neighbouring pixels may comprise the same or a smaller number of pixels. The first group of neighbouring pixels may be formed of a subset of pixels in the first block of pixels. The same is true of the second group of neighbouring pixels with respect to the second block of pixels.

At step 1303, the method involves determining a term (corresponding to the first and second pixels) based on the extent to which the difference between those pixels is determined as contributing to the determining the term. Steps 1301, 1302 and 1303 are then repeated for every pair of corresponding pixels in the first and second blocks until a term for every pair of corresponding pixels in the first and second blocks has been determined (step 1305).

When a term has been determined for every pixel in the first block of pixels, the method moves onto step 1306. The method at step 1306 involves calculating the combination of terms to determine the metric indicative of a similarity between the first block of pixels and the second block of pixels.

Each term of the metric is based on the extent to which the difference is determined to contribute to determining the term.. As previously mentioned, according to known methods, a metric indicative of similarity between the two blocks may be determined as a combination of terms based on the differences between corresponding pixels in the two blocks of pixels. For example, the metric may be determined as a sum of the differences between corresponding pixels in the two blocks of pixels. Therefore, the determined metric will be greater for two blocks which contain significantly different colour values than it would be for two blocks which appear quite similar. Thus, a lower value for the determined metric indicates a greater degree of similarity between the two blocks. A lower value therefore also indicates that the two blocks may represent the same object, for example that an object has moved from a position represented by the first block in the first frame to a position represented by the second block in the second frame.

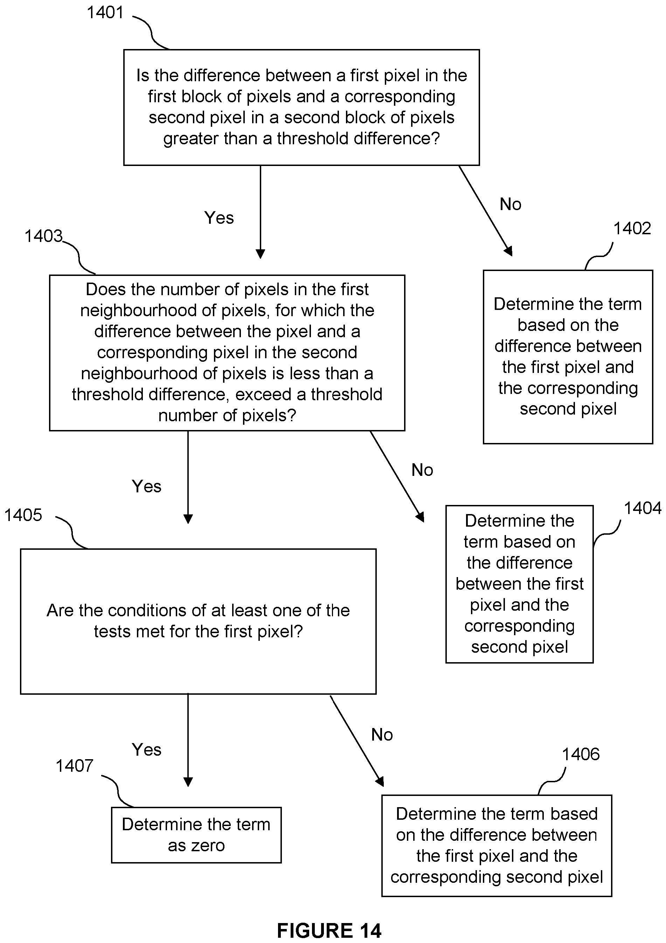

The method seen in figure 13 assumes it has been found that the difference between a first pixel in the first block of pixels and a corresponding second pixel in the second block of pixels is greater than a threshold difference. Figure 14 illustrates the process for determining the metric indicative of a similarity between a first block of pixels (e.g. 1203) and a second block of pixels (e.g. 1204) when the difference between a first pixel in the first block of pixels and a corresponding second pixel in the second block of pixels is greater than a threshold difference and when it is not greater than the threshold difference.

Step 1302 in the method previously described and shown in figure 13 involves analysing the pixels in at least one of the first group of neighbouring pixels in the first block of pixels and the second group of neighbouring pixels in the second block of pixels to determine the extent to which the difference is to contribute to determining term of the combination of terms. According to the example method seen in figure 14, this analysis may be performed by performing steps 1403 and and/or 1405 as seen in figure 14.

Step 1303 in the method previously described and shown in figure 13 involves determining a term based on the determined extent to which the difference is to contribute to determining the term. Figure 14 illustrates an example of how this term is determined in various scenarios, at steps 1402, 1404, 1406 and 1407.

For a first pixel in the first block and a corresponding pixel in the second block (e.g. pixels 1205 and 1206), at step 1401 it is determined whether the difference between the first pixel and the second pixel is greater than a threshold difference. If the difference is not greater than the threshold difference, at step 1402, a term is determined based on the difference between the first pixel and the second pixel. For example, the term may be determined as being equal to the difference between the pair of pixels. If the difference is greater than the threshold difference, as previously described, at step 1403, the method involves determining whether the number of pixels in the first region of pixels (in the first block), for which the difference between the pixel and a corresponding pixel in the second region of pixels (in the second block) is less than a threshold difference, exceed a threshold number of pixels. If the number of pixels does not exceed the threshold number of pixels, at step 1404, a term is determined based on the difference between the first pixel and the second pixel. For example, the term may be determined as being equal to the difference between the pair of pixels. If the number of pixels is greater than the threshold number of pixels, as previously described, at step 1405, the method involves determining whether the conditions of at least one of tests 1 to 5 are met for the first pixel.

However, if the conditions of none of tests 1 to 5 (as previously described) are met for the first pixel, at step 1406, a term is determined based on the difference between the first pixel and the second pixel. For example, the term may be determined as being equal to the difference between the pair of pixels or equal to the square of the difference between the pair of pixels.

In other words, in this example, analysing the pixels in at least one of a first group of neighbouring pixels in the first block of pixels and a second group of neighbouring pixels in the second block of pixels to determine an extent to which the difference is to contribute to determining the term of the combination of terms comprises performing steps 1403 and 1405. In a scenario in which the answers to the questions posed at steps 1403 and 11405 is "Yes", the term is determined as zero (at step 1407). If the conditions of at least one of the tests performed as part of step 1405 are met, this indicates that it is plausible that the difference between the first and second pixels is not due to the blocks representing different objects (e.g. the difference may be due to a slight rotation in an object between frames). In other words, the extent to which the difference contributes to determining the term is determined as being zero. To put it another way, the value of the difference between the first pixel and the second pixel does not contribute at all to the term determined for that pair of corresponding pixels.

As explained in more detail below, according to other examples, the term may be determined in step S1407 to be non-zero but less than it would be had none of the conditions been met in step S1405 i.e. 'reduced'.

The method seen in figure 14 is repeated for every pixel in the first block of pixels until a term has been determined for each pixel in the block. As seen in figure 13, the method then involves determining the metric indicative of the similarity between the two blocks of pixels by calculating a combination of the determined terms. For example, determining the metric may involve summing all of the determined terms.

In the example seen in figure 14, differences determined to be affected by e.g. small object rotations are given a value of 0 in the determined metric. Specifically, the difference is attached to a weighting factor of 0 such that the term is determined as being equal to the product of the difference and the weighting factor (i.e. the term equals zero). In other words, it is determined that the difference should not be taken into account when calculating the metric indicative of similarity between the first and second blocks of pixels. The value of the difference does not contribute to determining the term of the combination of terms used to calculate the metric. -in the example seen in figure 14, differences determined not to be affected by small object rotations are attached to a weighting factor of 1. The term is determined as being equal to the product of the difference and the weighting factor. In other words, the term of the metric is equal to the determined difference (i.e. the term is equal to the difference).

By assigning weighting factors in this way, some differences between pixels (e.g. due to slight rotations of objects between frames) do not contribute to the value of the metric indicative of the similarity between two blocks of pixels. The result may be that pixels representing objects which have slightly rotated between frames do not form part of the consideration of whether two blocks of pixels are similar.

As a further example, where it is determined that the difference should not contribute to determining the term (i.e. the extent to which the difference is to contribute to determining the term is determined as 'low' or 'reduced'), the term may be determined as having a constant (non-zero) value. The value of the difference between the two pixels therefore does not contribute to the determined term. For example, where the difference between the colour value of two pixels can be measured on a scale between 0 and 255, the term may be assigned a non-zero constant value not proportional to the value of the difference, for example a value of 10.

According to other examples, different weightings may be used. For example, where it is determined that the extent of the contribution the difference is to make to determining the term is low (i.e. reduced) e.g. because the difference is due to a small object rotation, the corresponding term of the metric may be determined as a product of the difference and a weighting factor, where the weighting factor has value between 0 and 1. For example, the difference may be attached to a weighting factor of 0.25, 0.5, 0.75. In this way, the effect of the term on the value of the overall metric is attenuated but not completely removed. In this example, where it is determined that a difference between a pair of pixels should contribute to determining the relevant term (i.e. because the difference is due to a true difference and not a small object rotation), the term corresponding to the pair of pixels may be determined as a product of the difference and weighting factor, where the weighting factor used is greater than the weighting factor used to calculate terms for which the determined extent of contribution is low. According to other examples, terms may be determined as being equal to the product of a weighting factor and the square of the difference.

Therefore, the metric indicative of the similarity between blocks of pixels can determined without the results being skewed by small object rotations.

The techniques described herein may therefore be used to more accurately determine the movement path of a block of pixels (e.g. representing an object) through a scene across a series of frames. Similar techniques may also be used for training a neural network.

Generally, any of the functions, methods, techniques or components described above can be implemented in software, firmware, hardware (e.g., fixed logic circuitry), or any combination thereof. The terms "module," "functionality," "component", "element", "unit", "block" and "logic" may be used herein to generally represent software, firmware, hardware, or any combination thereof. In the case of a software implementation, the module, functionality, component, element, unit, block or logic represents program code that performs the specified tasks when executed on a processor. The algorithms and methods described herein could be performed by one or more processors executing code that causes the processor(s) to perform the algorithms/methods. Examples of a computer-readable storage medium include a random-access memory (RAM), read-only memory (ROM), an optical disc, flash memory, hard disk memory, and other memory devices that may use magnetic, optical, and other techniques to store instructions or other data and that can be accessed by a machine.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

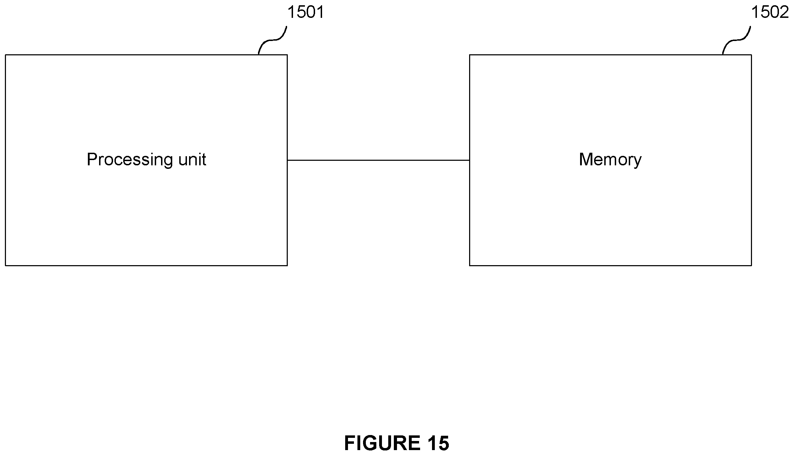

Figure 15 illustrates a computer system comprising a processing unit 1501 and a memory 1502. The methods described herein may be performed by a processing unit, such as the processing unit 1501 seen in figure 15. A computer system or processing unit may be any kind of device, machine or dedicated circuit, or collection or portion thereof, with processing capability such that it can execute instructions. A processing unit may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computer system may comprise one or more processing units.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

### ANNEX

Some numbered statements are provided below:
1. A method for determining a metric indicative of a similarity between a first block of pixels and a second block of pixels, wherein the metric is determined as a combination of terms based on the differences between corresponding pixels in the blocks of pixels, the method comprising:
   determining a term of the combination of terms for each pair of corresponding pixels in the first and second blocks of pixels by:
      determining a difference between a first pixel in the first block of pixels and a corresponding second pixel in the second block of pixels;
      in response to determining that the difference between the first pixel and the second pixel is greater than a threshold difference, analysing the pixels in at least one of a first group of neighbouring pixels in the first block of pixels and a second group of neighbouring pixels in the second block of pixels to determine an extent to which the difference is to contribute to determining the term of the combination of terms wherein the first pixel is in the first group of neighbouring pixels and the second pixel is in the second group of neighbouring pixels; and
      determining the term of the combination of terms based on the determination of the extent to which the difference is to contribute to determining the term of the combination of terms; and
   determining the metric indicative of the similarity between the first block of pixels and the second block of pixels by calculating the combination of terms.
2. The method of statement 1, wherein a first region of pixels comprises the first group of neighbouring pixels, a second region of pixels comprises the second group of neighbouring pixels, the first block of pixels comprises the first region of pixels and the second block of pixels comprises the second region of pixels, and wherein analysing the pixels in at least one of the first and second groups of neighbouring pixels to determine the extent to which the difference is to contribute to determining the term of the combination of terms comprises:
   determining, for each pixel in the first region, a difference between the pixel and a corresponding pixel in the second region and whether the difference between the pixel and the corresponding pixel is greater than a second threshold difference;
   calculating the number of pixels in the first region for which the difference between the pixel and the corresponding pixel is less than the second threshold difference; and
   determining whether the number of pixels in the first region for which the difference between the pixel and the corresponding pixel is less than the second threshold difference is greater than a threshold number of pixels.
3. The method of statement 2, wherein the first region of pixels is the first group of neighbouring pixels and the second region of pixels is the second group of neighbouring pixels.
4. The method of any preceding statement, wherein analysing the pixels in at least one of the first and second groups of neighbouring pixels to determine the extent to which the difference is to contribute to determining the term of the combination of terms comprises:
   determining whether a difference between the first pixel and each of the pixels in the second group of neighbouring pixels is greater than a third threshold difference.
5. The method of statement 4, the method comprising determining that the extent to which the difference is to contribute to determining the term of the combination of terms is reduced in response to determining that the difference between the first pixel and at least one of the pixels in the second group of neighbouring pixels is less than the third threshold difference.
6. The method of any preceding statement, wherein analysing the pixels in at least one of the first and second groups of neighbouring pixels to determine the extent to which the difference is to contribute to determining the term of the combination of terms comprises:
   determining whether a difference between the first pixel and each of the pixels in the first group of neighbouring pixels is greater than a fourth threshold difference;
   determining a primary connection between the first pixel and any pixel in the first group of neighbouring pixels for which the difference between the two pixels is not greater than the fourth threshold difference;
   determining whether a difference between each pixel in the first group of neighbouring pixels and each adjacent pixel in the first group of neighbouring pixels is greater than the fourth threshold difference;
   determining a secondary connection between any two adjacent pixels in the first group of neighbouring pixels for which the difference between the two pixels is not greater than the fourth threshold difference;
   determining whether the number of primary connections determined between the first pixel and the first group of neighbouring pixels is greater than a first connection threshold;
   determining a total number of connections as the sum of the number of primary connections and the number of secondary connections; and
   determining whether the total number of connections determined within the first group of neighbouring pixels is greater than a second connection threshold.
7. The method of statement 6, wherein analysing the pixels in at least one of the first and second groups of neighbouring pixels to determine the extent to which the difference is to contribute to determining the term of the combination of terms comprises:
   determining whether a difference between the second pixel and each of the pixels in the second group of neighbouring pixels is greater than the fourth threshold difference;
   determining whether a difference between each pixel in the second group of neighbouring pixels and each adjacent pixel in the second group of neighbouring pixels is greater than the fourth threshold difference;
   determining a primary connection between the second pixel and any pixel in the second group of neighbouring pixels for which the difference between the two pixels is not greater than the fourth threshold difference;
   determining a secondary connection between any two adjacent pixels in the second group of neighbouring pixels for which the difference between the two pixels is not greater than the fourth threshold difference;
   determining whether the number of primary connections determined between the second pixel and the second group of neighbouring pixels is greater than the first connection threshold;
   determining a total number of connections as the sum of the number of primary connections and the number of secondary connections; and
   determining whether the number of connections determined within the second group of neighbouring pixels is greater than the second connection threshold.
8. The method of statement 7, the method comprising determining that the extent to which the difference is to contribute to determining the term of the combination of terms is reduced in response to determining that:
   the number of primary connections determined between the first pixel and the first group of neighbouring pixels is greater than the first connection threshold;
   the total number of connections determined within the first group of neighbouring pixels is greater than the second connection threshold;
   the number of primary connections determined between the second pixel and the second group of neighbouring pixels is greater than the first connection threshold; and
   the total number of connections determined within the second group of neighbouring pixels is greater than the second connection threshold.
9. The method of any preceding statement, wherein analysing the pixels in at least one of the first and second groups of neighbouring pixels to determine the extent to which the difference is to contribute to determining the term of the combination of terms comprises, for each pair of pixels in the first group of neighbouring pixels which flank the first pixel:
   comparing a colour value of each pixel of the pair of flanking pixels to a colour value of the first pixel; and
   determining whether the colour value of the first pixel lies between the colour value of a first flanking pixel in the pair of flanking pixels and the colour value of a second flanking pixel in the pair of flanking pixels for a plurality of channels of the colour values.
10. The method of statement 9, the method comprising determining that the extent to which the difference is to contribute to determining the term of the combination of terms is reduced in response to determining that the colour value of the first pixel lies between the colour value of a first flanking pixel in the pair of flanking pixels and the colour value of a second flanking pixel in the pair of flanking pixels for the plurality of channels of the colour values.
11. The method of any preceding statement, wherein analysing the pixels in at least one of the first and second groups of neighbouring pixels to determine the extent to which the difference is to contribute to determining the term of the combination of terms comprises, for each pair of pixels in the second group of neighbouring pixels which flank the second pixel:
   comparing a colour value of each pixel of the pair of flanking pixels to a colour value of the second pixel; and
   determining whether the colour value of the second pixel lies between the colour value of a first flanking pixel in the pair of flank pixels and the colour value of a second flanking pixel in the pair of flanking pixels for a plurality of channels of the colour values.
12. The method of statement 11, the method comprising determining that the extent to which the difference is to contribute to determining the term of the combination of terms is reduced in response to determining that the colour value of the second pixel lies between the colour value of a first flanking pixel in the pair of flanking pixels and the colour value of a second flanking pixel in the pair of flanking pixels for the plurality of channels of the colour values.
13. The method of any of statement 9 to 12, wherein the plurality of channels are all the channels of the colour values.
14. The method of any preceding statement, wherein analysing the pixels in at least one of the first and second groups of neighbouring pixels comprises analysing the pixels in both the first and second groups of neighbouring pixels.
15. The method of any preceding statement, wherein analysing the pixels in at least one of the first and second groups of neighbouring pixels to determine the extent to which the difference is to contribute to determining the term of the combination of terms comprises:
   for the first group of neighbouring pixels,
      comparing a colour value of the first pixel to a corresponding colour value of each of the pixels in the first group of neighbouring pixels;
      determining whether the colour value of the first pixel is greater or less than the colour value of all of the pixels in the first group of neighbouring pixels for all channels of the colour values; and
   for the second group of neighbouring pixels,
      comparing a colour value of the second pixel to a corresponding colour value of each of the pixels in the second group of neighbouring pixels;
      determining whether the colour value of the second pixel is greater or less than the colour value of all of the pixels in the second group of neighbouring pixels for all channels
   of the colour values;
      and
   determining whether a difference between the first pixel and the second pixel is less than a fifth threshold difference.
16. The method of statement 15, the method comprising determining that the extent to which the difference is to contribute to determining the term of the combination of terms is reduced in response to determining that:
   the colour value of the first pixel is greater than the colour value of all of the pixels in the first group of neighbouring pixels for all channels in the colour values and the colour value of the second pixel is greater than the colour value of all of the pixels in the second group of neighbouring pixels for all channels in the colour values; or
   the colour value of the first pixel is less than the colour value of all of the pixels in the first group of neighbouring pixels for all channels in the colour values the colour value of the second pixel is less than the colour value of all of the pixels in the second group of neighbouring pixels for all channels in the colour values; and
   that difference between the first pixel and the second pixel is less than the fifth threshold difference.
17. The method of any of statements 11 to 16 when dependent upon statements 6 and 11, the method comprising determining that the extent to which the difference is to contribute to determining the term of the combination of terms is reduced in response to determining that:
   the number of primary connections determined between the first pixel and the first group of neighbouring pixels is greater than the first connection threshold;
   the number of secondary connections determined within the first group of neighbouring pixels is greater than the second connection threshold; and
   the colour value of the second pixel lies between the colour value of a first flanking pixel in the pair of flanking pixels and the colour value of a second flanking pixel in the pair of flanking pixels for all channels of the colour values.
18. The method of any of statements 11 to 17 when dependent upon statements 6 and 11, the method comprising determining that the extent to which the difference is to contribute to determining the term of the combination of terms is reduced in response to determining that:
   the number of primary connections determined between the second pixel and the second group of neighbouring pixels is greater than the first connection threshold;
   the number of secondary connections determined within the second group of neighbouring pixels is greater than the second connection threshold; and
   the colour value of the first pixel lies between the colour value of a first flanking pixel in the pair of flanking pixels and the colour value of a second flanking pixel in the pair of flanking pixels for all channels of the colour values.
19. The method of any preceding statement, wherein the first block of pixels is in a first frame of a series of frames and the second block of pixels is in a second frame of a series of frames.
20. The method of any preceding statement, wherein the first group of neighbouring pixels is a square of 3 pixels by 3 pixels and the second group of neighbouring pixels is a square of 3 pixels by 3 pixels.
21. The method of any preceding statement, wherein determining the extent to which the difference is to contribute to determining the term of the combination of terms comprises determining that the difference does not contribute to determining the term.
22. The method of statement 21, wherein determining the term of the combination of terms comprises determining the term as zero.
23. The method of any preceding statement, wherein determining the extent to which the difference is to contribute to determining the term of the combination of terms comprises determining that the difference does contribute to determining the term.
24. The method of statement 23, wherein determining the term of the combination of terms comprises determining the term as equal to the difference or equal to the square of the difference.
25. The method of any preceding statement, the method further comprising using the metric as part of a motion estimation algorithm.
26. The method of any of statements 1 to 24, the method further comprising using the metric as part of training a neural network to perform image recognition.
27. The method of any preceding statement, wherein the combination of terms is a sum of terms.
28. The method of statement 27, wherein the sum of terms is a sum of absolute differences or a sum of squared differences.
29. A processing unit configured to determine a metric indicative of a similarity between a first block of pixels and a second block of pixels, wherein the metric is determined as a combination of terms based on the differences between corresponding pixels in the blocks of pixels, the processing unit being configured to:
   determine a term of the combination of terms for each pair of corresponding pixels in the first and second blocks of pixels by:
      determining a difference between a first pixel in the first block of pixels and a corresponding second pixel in the second block of pixels;
      in response to determining that the difference between the first pixel and the second pixel is greater than a threshold difference, analysing the pixels in at least one of a first group of neighbouring pixels in the first block of pixels and a second group of neighbouring pixels in the second block of pixels to determine an extent to which the difference is to contribute to determining the term of the combination of terms, wherein the first pixel is in the first group of neighbouring pixels and the second pixel is in the second group of neighbouring pixels; and
      determining the term of the combination of terms based on the determination of the extent to which the difference is to contribute to determining the term of the combination of terms; and
   determine the metric indicative of the similarity between the first block of pixels and the second block of pixels by calculating the combination of terms.
30. Computer readable code configured to cause the method of any of statements 1 to 28 to be performed when the code is run.

## Claims

1. A method of classifying a first pixel in a first group of neighbouring pixels as acceptable or not acceptable with respect to a second pixel in a second group of neighbouring pixels, the method comprising:
determining whether a difference between the first pixel and the second pixel is greater than a threshold difference;
in response to determining that the difference between the first pixel and the second pixel is greater than the threshold difference, analysing the pixels in at least one of the first and second groups of neighbouring pixels to determine whether the difference is indicative of the first pixel being erroneous;
classifying the first pixel as acceptable or not acceptable based on whether the difference is determined to be indicative of the first pixel being erroneous; and
outputting the classification of the first pixel.

2. The method of claim 1, wherein a first region of pixels comprises the first group of neighbouring pixels and a second region of pixels comprises the second group of neighbouring pixels, and wherein analysing the pixels in at least one of the first and second groups of neighbouring pixels to determine whether the difference is indicative of the first pixel being erroneous comprises:
determining, for each pixel in the first region, a difference between the pixel and a corresponding pixel in the second region and whether the difference between the pixel and the corresponding pixel is greater than a second threshold difference;
calculating the number of pixels in the first region for which the difference between the pixel and the corresponding pixel is less than the second threshold difference; and
determining whether the number of pixels in the first region for which the difference between the pixel and the corresponding pixel is less than the second threshold difference is greater than a threshold number of pixels.

3. The method of claim 2, wherein the first region of pixels is the first group of neighbouring pixels and the second region of pixels is the second group of neighbouring pixels.

4. The method of any preceding claim, wherein analysing the pixels in at least one of the first and second groups of neighbouring pixels to determine whether the difference is indicative of the first pixel being erroneous comprises:
determining whether a difference between the first pixel and each of the pixels in the second group of neighbouring pixels is greater than a third threshold difference.

5. The method of claim 4, the method comprising classifying the first pixel as acceptable in response to determining that the difference between the first pixel and at least one of the pixels in the second group of neighbouring pixels is less than the third threshold difference.

6. The method of any preceding claim, wherein analysing the pixels in at least one of the first and second groups of neighbouring pixels to determine whether the difference is indicative of the first pixel being erroneous comprises:
determining whether a difference between the first pixel and each of the pixels in the first group of neighbouring pixels is greater than a fourth threshold difference;
determining a primary connection between the first pixel and any pixel in the first group of neighbouring pixels for which the difference between the two pixels is not greater than the fourth threshold difference;
determining whether a difference between each pixel in the first group of neighbouring pixels and each adjacent pixel in the first group of neighbouring pixels is greater than the fourth threshold difference;
determining a secondary connection between any two adjacent pixels in the first group of neighbouring pixels for which the difference between the two pixels is not greater than the fourth threshold difference;
determining whether the number of primary connections determined between the first pixel and the first group of neighbouring pixels is greater than a first connection threshold;
determining a total number of connections as the sum of the number of primary connections and the number of secondary connections; and
determining whether the total number of connections determined within the first group of neighbouring pixels is greater than a second connection threshold.

7. The method of claim 6, wherein analysing the pixels in at least one of the first and second groups of neighbouring pixels to determine whether the difference is indicative of the first pixel being erroneous comprises:
determining whether a difference between the second pixel and each of the pixels in the second group of neighbouring pixels is greater than the fourth threshold difference;
determining whether a difference between each pixel in the second group of neighbouring pixels and each adjacent pixel in the second group of neighbouring pixels is greater than the fourth threshold difference;
determining a primary connection between the second pixel and any pixel in the second group of neighbouring pixels for which the difference between the two pixels is not greater than the fourth threshold difference;
determining a secondary connection between any two adjacent pixels in the second group of neighbouring pixels for which the difference between the two pixels is not greater than the fourth threshold difference;
determining whether the number of primary connections determined between the second pixel and the second group of neighbouring pixels is greater than the first connection threshold;
determining a total number of connections as the sum of the number of primary connections and the number of secondary connections; and
determining whether the total number of connections determined within the second group of neighbouring pixels is greater than the second connection threshold.

8. The method of claim 7, the method comprising classifying the first pixel as acceptable in response to determining that:
the number of primary connections determined between the first pixel and the first group of neighbouring pixels is greater than the first connection threshold;
the total number of connections determined within the first group of neighbouring pixels is greater than the second connection threshold;
the number of primary connections determined between the second pixel and the second group of neighbouring pixels is greater than the first connection threshold; and
the total number of connections determined within the second group of neighbouring pixels is greater than the second connection threshold.

9. The method of any preceding claim, wherein analysing the pixels in at least one of the first and second groups of neighbouring pixels to determine whether the difference is indicative of the first pixel being erroneous comprises, for each pair of pixels in the first group of neighbouring pixels which flank the first pixel:
comparing a colour value of each pixel of the pair of flanking pixels to a colour value of the first pixel;
determining whether the colour value of the first pixel lies between the colour value of a first flanking pixel in the pair of flanking pixels and the colour value of a second flanking pixel in the pair of flanking pixels for a plurality of channels of the colour values; and
optionally classifying the first pixel as acceptable in response to determining that, for at least one pair of flanking pixels comprising a first flanking pixel and a second flanking pixel, the colour value of the first pixel lies between the colour value of the first flanking pixel and the colour value of the second flanking pixel for the plurality of channels of the colour values.

10. The method of any preceding claim, wherein analysing the pixels in at least one of the first and second groups of neighbouring pixels to determine whether the difference is indicative of the first pixel being erroneous comprises, for each pair of pixels in the second group of neighbouring pixels which flank the second pixel:
comparing a colour value of each pixel of the pair of flanking pixels to a colour value of the second pixel;
determining whether the colour value of the second pixel lies between the colour value of a first flanking pixel in the pair of flank pixels and the colour value of a second flanking pixel in the pair of flanking pixels for a plurality of channels of the colour values; and
optionally classifying the first pixel as acceptable in response to determining that, for at least one pair of flanking pixels comprising a first flanking pixel and a second flanking pixel, the colour value of the second pixel lies between the colour value of the first flanking pixel and the colour value of the second flanking pixel for the plurality of channels of the colour values.

11. The method of any preceding claim, wherein analysing the pixels in at least one of the first and second groups of neighbouring pixels to determine whether the difference is indicative of the first pixel being erroneous comprises:
for the first group of neighbouring pixels,
comparing a colour value of the first pixel to a corresponding colour value of each of the pixels in the first group of neighbouring pixels; and
determining whether the colour value of the first pixel is greater or less than the colour value of all of the pixels in the first group of neighbouring pixels for all channels of the colour values; and
for the second group of neighbouring pixels,
comparing a colour value of the second pixel to a corresponding colour value of each of the pixels in the second group of neighbouring pixels; and
determining whether the colour value of the second pixel is greater or less than the colour value of all of the pixels in the second group of neighbouring pixels for all channels
of the colour values;
and
determining whether a difference between the first pixel and the second pixel is less than a fifth threshold difference.

12. The method of claim 11, the method comprising classifying the first pixel as acceptable in response to determining that:
the colour value of the first pixel is greater than the colour value of all of the pixels in the first group of neighbouring pixels for all channels in the colour values and the colour value of the second pixel is greater than the colour value of all of the pixels in the second group of neighbouring pixels for all channels in the colour values; or
the colour value of the first pixel is less than the colour value of all of the pixels in the first group of neighbouring pixels for all channels in the colour values the colour value of the second pixel is less than the colour value of all of the pixels in the second group of neighbouring pixels for all channels in the colour values; and
that difference between the first pixel and the second pixel is less than the fifth threshold difference.

13. The method of any preceding claim, wherein classifying the first pixel as acceptable indicates that the difference is indicative of floating point rounding.

14. A processing unit configured to classify a first pixel in a first group of neighbouring pixels as acceptable or not acceptable with respect to a second pixel in a second group of neighbouring pixels, the processing unit being configured to:
determine whether a difference between the first pixel and the second pixel is greater than a threshold difference;
in response to determining that the difference between the first pixel and the second pixel is greater than the threshold difference, analyse the pixels in at least one of the first and second groups of neighbouring pixels to determine whether the difference is indicative of the first pixel being erroneous;
classify the first pixel as acceptable or not acceptable based on whether the difference is determined to be indicative of the first pixel being erroneous; and
output the classification of the first pixel.

15. A computer readable storage medium having encoded thereon computer readable code configured to cause the method of any of claims 1 to 13 to be performed when the code is run.
